# EUROPEAN PATENT SPECIFICATION

(11) **EP 4 177 932 B1**
(45) Date of publication and mention of the grant of the patent: **23.04.2025**
(21) Application number: 22203226.0
(22) Date of filing: 24.10.2022
(51) Int. Cl.: H01L 21/02

(54) **MATERIAL FOR FORMING FILLING FILM FOR INHIBITING SEMICONDUCTOR SUBSTRATE PATTERN COLLAPSE, AND METHOD FOR TREATING SEMICONDUCTOR SUBSTRATE**
MATERIAL ZUR BILDUNG EINES FÜLLFILMS ZUR VERHINDERUNG DES KOLLABIERENS EINER HALBLEITERSUBSTRATSTRUKTUR UND VERFAHREN ZUR BEHANDLUNG EINES HALBLEITERSUBSTRATS
MATÉRIAU POUR FORMER UN FILM DE REMPLISSAGE POUR INHIBER L'AFFAISSEMENT D'UN MOTIF DE SUBSTRAT SEMI-CONDUCTEUR, ET PROCÉDÉ DE TRAITEMENT D'UN SUBSTRAT SEMI-CONDUCTEUR

(30) Priority: 09.11.2021 JP 2021182846
(43) Date of publication of application: 10.05.2023
(73) Proprietor: SHIN-ETSU CHEMICAL CO., LTD., Tokyo 1000005 (JP)
(72) Inventor: Kobayashi, Naoki, Niigata (JP); Kori, Daisuke, Niigata (JP); Niida, Keisuke, Niigata (JP); Yano, Toshiharu, Niigata (JP)
(74) Representative: Sonnenhauser, Thomas Martin

(56) References cited:
- EP-A1- 2 905 803
- JP-B2- 6 550 760
- US-A1- 2014 220 783

## Description

### TECHNICAL FIELD

The present invention relates to a material for forming a filling film for inhibiting semiconductor substrate pattern collapse, and a method for treating a semiconductor substrate.

### BACKGROUND ART

In manufacturing processes of semiconductor devices, Micro Electro Mechanical Systems (MEMS), and so forth, substrates (to be processed) are treated with a liquid. For example, a substrate, a laminate film, a resist film, and the like are patterned by liquid treatment, so that a fine structure is formed on the substrate. Moreover, impurity, residue, and the like remaining on the substrate are removed by washing with a liquid. Further, these steps are performed in combination. Then, when the liquid is to be removed after the liquid treatment, a fine structure formed on the substrate sometimes collapse due to the surface tension of the liquid.

Meanwhile, along with the advancement in size reduction, higher integration, or higher processing speed of semiconductor devices for networks and digital household appliances, miniaturization of substrate patterns has been in progress. Along with this progress of substrate pattern miniaturization, higher aspect ratio (ratio of height and width in a pattern) causes such an inconvenience that the substrate pattern is likely to collapse when the gas-liquid interface passes through the pattern in drying the wafer after washing or rinsing. Examples of the fine structure pattern that likely results in substrate pattern collapse include line-and-space pattern in FinFet structure of Logic, line-and-space pattern and island pattern in STI (Shallow Trench Isolation) structure of DRAM (Dynamic Random Access Memory), pillar pattern in capacitor structure of DRAM, hole pattern and slit pattern in cell structure of 3D-NAND, etc. Since no effective countermeasure against this inconvenience has been found, it is necessary to, for example, design a pattern that does not cause pattern collapse so as to attain size reduction, high integration, or high processing speed of semiconductor devices and micro-machines. Hence, pattern design freedom is significantly restricted in the current situation.

Patent Document 1 discloses, as an approach for inhibiting substrate pattern collapse, a technique of changing the washing liquid from water to 2-propanol before the gas-liquid interface passes through the pattern. However, there are such limits that the manageable pattern aspect ratio is 5 or less, for example.

Patent Document 2 discloses a cleaning method including: performing surface modification, such as oxidization, on a wafer surface having an uneven profile pattern formed from a silicon-containing film; and forming a water-repellent protection film on the surface by using a water-soluble surfactant or silane coupling agent to reduce the capillary force and thereby prevent pattern collapse.

Patent Document 3 discloses a technique for preventing substrate pattern collapse by hydrophobilization using a treatment liquid containing a solvent and a silylating agent such as N,N-dimethylaminotrimethylsilane.

Patent Document 4 proposes a method including: washing an uneven pattern-formed substrate with a rinsing liquid; then, replacing the rinsing liquid left inside recesses of the pattern with a treatment liquid for filling, the treatment liquid containing a sublimable substance, such as camphor and naphthalene, so that the recesses of the pattern are filled with the treatment liquid; depositing the sublimable substance from the treatment liquid; and removing the deposited solid sublimable substance by sublimation. However, it is disclosed that general methods employing sublimable substances often fail to sufficiently fill pattern recesses with the sublimable substances, and the effect of inhibiting substrate-surface pattern collapse is not sufficient.

Patent Document 5 discloses a technique for preventing substrate pattern collapse by forming a filling film through application of a treatment agent for inhibiting substrate pattern collapse to a patterned surface of a substrate having a pattern formed on one surface, the treatment agent being characterized by containing a compound having an aromatic ring and a solvent. Patent Document 6 discloses a technique for preventing substrate pattern collapse by forming a filling film through application of a treatment agent for inhibiting substrate pattern collapse characterized by containing a hydroxy group-containing vinyl-based polymer and a solvent. The filling film needs to be heated in order to keep the strength of the substrate pattern by suppressing this thermal melting of the filling film when it is removed by dry etching or the like. However, with the composition containing only the compound having many hydrophilic groups and a solvent, the residual solvent which the compound has is hardly removed from the filling film at the bottom portion of the pattern during the heating, and foams in the filling film, thereby forming voids. Accordingly, this composition does not exhibit a sufficient anti-collapse effect on fine-structure pattern with high aspect ratio.

Patent Document 7 discloses a composition for forming a resist underlayer film for multilayer resist processes, the composition being characterized by containing a particular polymer, a particular crosslinking agent, an acid generator, and a solvent. This composition can form a thick film excellent in storage stability and crack resistance. However, the filling property exhibited by the combination of a particular polymer and a particular crosslinking agent is insufficient for a pattern substrate with high aspect ratio. From the foregoing, there have been demands for a material for forming a filling film for inhibiting pattern collapse, the material being excellent in filling property for a fine structure pattern with high aspect ratio.

### CITATION LIST

### PATENT LITERATURE

Patent Document 1: JP 2008-198958 A
Patent Document 2: JP 4403202 B
Patent Document 3: JP 2010-129932 A
Patent Document 4: JP 2013-042093 A
Patent Document 5: WO 2018/074535 A1
Patent Document 6: JP 6718123 B
Patent Document 7: JP 6550760 B

### SUMMARY OF INVENTION

### TECHNICAL PROBLEM

The present invention has been made based on the above circumstances. An object of the present invention is to provide: a material for forming a filling film for inhibiting semiconductor substrate pattern collapse, the resulting filling film being capable of filling a fine structure pattern having high aspect ratio without causing voids; and a method for treating a semiconductor substrate to successfully inhibit semiconductor substrate pattern collapse.

### SOLUTION TO PROBLEM

To achieve the object, the present invention provides a material for forming a filling film for inhibiting semiconductor substrate pattern collapse, comprising:
(A) a polymer having a structural unit shown by the following general formula (1);
(B) a residual-solvent removal promoter containing a compound shown by the following general formula (2); and
(C) an organic solvent,

wherein a ratio Mw/Mn of a weight-average molecular weight Mw and a number-average molecular weight Mn of the polymer (A) in terms of polystyrene by a gel permeation chromatography method is 2.50≤Mw/Mn≤9.00,
the residual-solvent removal promoter (B) is contained in an amount of 0.1 to 40 parts by mass based on 100 parts by mass of the polymer (A), and
the material for forming a filling film for inhibiting semiconductor substrate pattern collapse comprises no acid generator, 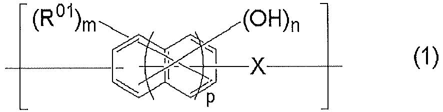
   wherein R⁰¹ represents a saturated or unsaturated monovalent organic group having 1 to 30 carbon atoms; X represents a divalent organic group having 1 to 30 carbon atoms; "m" represents an integer of 0 to 5, "n" represents an integer of 1 to 6, and m+n is an integer of 1 or more and 6 or less; and "p" represents 0 or 1, 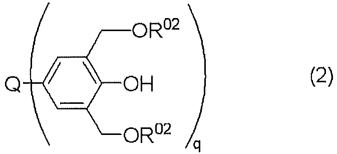
   wherein Q represents a single bond, or a hydrocarbon group with a valency of "q" having 1 to 20 carbon atoms; R⁰² represents a hydrogen atom or a methyl group; and "q" represents an integer of 1 to 5.

With such a material for forming a filling film for inhibiting semiconductor substrate pattern collapse, when the filling film is heated after a high-aspect-ratio-pattern substrate is filled therewith, the residual-solvent removal promoter (B) promotes the removal of a residual solvent possessed by the polymer (A) in the filling film, allowing filling film formation without voids. This makes it possible to provide a treatment method which favorably inhibits substrate pattern collapse after the filling film is removed. Moreover, since the material for forming a filling film for inhibiting semiconductor substrate pattern collapse contains the polymer (A) having a molecular weight dispersity within the above range, the material has high flowability, so that a high-aspect-ratio-pattern substrate is effectively filled therewith. Further, the film formability is excellent, and generation of sublimation products is suppressed during heating, so that contamination of the apparatus due to the sublimation products can be suppressed. Furthermore, the material for forming a filling film for inhibiting semiconductor substrate pattern collapse is excellent and effective in reducing coating defect and residues after the filling-film removal. Furthermore, when the filling film filling a substrate pattern is heated, the crosslinking reaction between the polymer (A) and the residual-solvent removal promoter (B) moderately proceeds, and the residual-solvent removal promoter (B) promotes the removal of the residual solvent possessed by the polymer (A) in the filling film, thereby enabling formation of a void-free filling film.

Moreover, in the present invention, the polymer (A) preferably has a structural unit shown by the following general formula (3) in addition to the structural unit of the general formula (1), 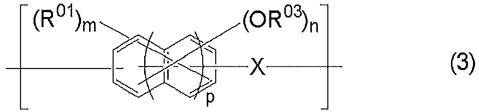 wherein R⁰³ represents a saturated or unsaturated monovalent organic group having 1 to 30 carbon atoms; "m" represents an integer of 0 to 5, "n" represents an integer of 1 to 6, and m+n is an integer of 1 or more and 6 or less; "p" represents 0 or 1; and R⁰¹ and X are as defined above.

Incorporating a polymer as shown by the general formula (3) into the material for forming a filling film for inhibiting semiconductor substrate pattern collapse increases the flowability, and a high-aspect-ratio-pattern substrate is filled more effectively. Moreover, the affinity to a polar solvent is so low that the residual solvent amount in the filling film is effectively reduced.

Further, in the present invention, R⁰³ in the general formula (3) preferably represents an alkyl group having 1 to 30 carbon atoms, or any of structures shown in the following general formula (4), 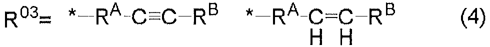 wherein * represents an attachment point to an oxygen atom, R^{A} represents a divalent organic group having 1 to 10 carbon atoms optionally having a substituent, and R^{B} represents a hydrogen atom or a monovalent organic group having 1 to 10 carbon atoms optionally having a substituent.

Incorporating such a polymer (A) into the material for forming a filling film for inhibiting semiconductor substrate pattern collapse further increases the flowability, so that a high-aspect-ratio-pattern substrate is filled further effectively. Since the affinity to a polar solvent is low, the residual solvent amount in the filling film is also effectively reduced. Further, the crosslinking reactivity is increased, so that the inventive material has excellent film formability and solvent resistance, generation of sublimation products is suppressed during heating, and the contamination of the apparatus due to the sublimation products can be suppressed. The material for forming a filling film for inhibiting semiconductor substrate pattern collapse is further excellent and effective in reducing coating defect and residues after the filling-film removal.

More preferably, in the present invention, the structural unit of the general formula (3) is contained in an amount satisfying relations of a+b=100 and b≤90, where "a" represents a proportion of the general formula (1), and "b" represents a proportion of the general formula (3).

Incorporating such a polymer (A) into the material for forming a filling film for inhibiting semiconductor substrate pattern collapse makes it possible to suppress degradation of adhesiveness between the filling film and the substrate pattern, and reduce cracking in the filling film. Moreover, when a washing liquid held in recesses is replaced, a high-aspect-ratio-pattern substrate is effectively filled because of higher affinity.

Further, in the present invention, the organic solvent (C) preferably comprises a high-boiling-point solvent.

Such an organic solvent (C) is practically preferable because fine adjustment of performances, such as film formability and filling property, is possible according to client demands.

Furthermore, in the present invention, the high-boiling-point solvent preferably comprises one or more organic solvents each having a boiling point of 180°C or higher.

Such a material for forming a filling film for inhibiting semiconductor substrate pattern collapse has higher flowability, so that a high-aspect-ratio-pattern substrate is further effectively filled therewith.

Additionally, in the present invention, the material for forming a filling film for inhibiting semiconductor substrate pattern collapse preferably further comprises (D) a surfactant.

Such a material for forming a filling film for inhibiting semiconductor substrate pattern collapse is practically preferable because fine adjustment of performances, such as film formability and filling property, is possible according to client demands.

Furthermore, in the present invention, a metal impurity amount in the material for forming a filling film for inhibiting semiconductor substrate pattern collapse is preferably 3 ppb or less by mass.

Furthermore, in the present invention, the metal is preferably selected from Na, Mg, K, Ca, Mn, Fe, Ni, Cu and Ti.

The use of such materials for forming a filling film for inhibiting semiconductor substrate pattern collapse as described above makes it possible to reduce the metal impurity amount on the substrate surface after the filling film is removed from the substrate pattern.

In addition, the present invention provides a method for treating a semiconductor substrate, the method comprising steps of:
forming a filling film by using the above-described material for forming a filling film for inhibiting semiconductor substrate pattern collapse to fill a semiconductor substrate having an uneven pattern formed on a surface thereof, the substrate having an aspect ratio of 5 or more; and
removing the filling film.

In this manner, the inventive material for forming a filling film for inhibiting substrate pattern collapse is suitably employable as a filling film for a substrate having a surface with an uneven pattern formed thereon and with an aspect ratio of 5 or more. The inventive material is excellent in performance of inhibiting substrate-pattern collapse after the filling film is removed. Thus, the inventive material is suitably employable in a substrate-pattern-collapse inhibitory process for inhibiting fall or collapse which would otherwise occur in drying a washing liquid or rinsing liquid after the substrate pattern washing.

Moreover, the present invention provides a method for treating a semiconductor substrate having an uneven pattern formed on a surface thereof to dry the semiconductor substrate, the method comprising steps of:
(1) washing the pattern-formed semiconductor substrate with a washing liquid, or washing the pattern-formed semiconductor substrate with a washing liquid and then replacing the washing liquid with a rinsing liquid;
(2) filling the pattern with a filling film in place of the washing liquid or rinsing liquid by using the above-described material for forming a filling film for inhibiting semiconductor substrate pattern collapse;
(3) curing the filling film by heating at a temperature of 100°C or higher and 600°C or lower for 10 to 600 seconds; and
(4) removing the cured filling film from the semiconductor substrate by dry etching.

In this manner, the inventive material for forming a filling film for inhibiting semiconductor substrate pattern collapse is suitably employable as a filling film for a substrate having a surface with an uneven pattern formed thereon. Since the inventive material is excellent in performance of inhibiting substrate pattern collapse after the filling-film removal, the inventive material is suitable in a semiconductor-substrate-pattern-collapse inhibitory process for inhibiting fall or collapse which would otherwise occur in drying up washing liquid or rinsing liquid after the substrate pattern washing.

Further, the present invention provides a method for treating a semiconductor substrate having a first uneven pattern formed on a surface thereof to dry the semiconductor substrate and to form a second uneven pattern different from the first uneven pattern in the semiconductor substrate, the method comprising steps of:
(1) washing the pattern-formed semiconductor substrate with a washing liquid, or washing the pattern-formed semiconductor substrate with a washing liquid and then replacing the washing liquid with a rinsing liquid;
(2) filling the pattern with a filling film in place of the washing liquid or rinsing liquid by using the above-described material for forming a filling film for inhibiting semiconductor substrate pattern collapse;
(3) curing the filling film by heating at a temperature of 100°C or higher and 600°C or lower for 10 to 600 seconds;
(4) forming a silicon-containing resist middle layer film on the cured filling film by using a silicon-containing resist middle layer film material;
(5) forming a resist upper layer film on the silicon-containing resist middle layer film by using a photoresist composition;
(6) forming a circuit pattern in the resist upper layer film;
(7) transferring the pattern to the silicon-containing resist middle layer film by etching while using the circuit pattern-formed resist upper layer film as a mask;
(8) transferring the pattern to the cured filling film by etching while using the pattern-transferred silicon-containing resist middle layer film as a mask;
(9) forming the second uneven pattern different from the first uneven pattern in the semiconductor substrate having the first uneven pattern formed on the surface by etching while using the pattern-transferred cured filling film as a mask; and
(10) removing the cured filling film from the semiconductor substrate by dry etching.

In this manner, the inventive material for forming a filling film for inhibiting semiconductor substrate pattern collapse is suitably employable as a resist underlayer film for multilayer resist process to fill a substrate having an uneven pattern formed on a surface thereof. Thus, it is possible to omit steps of: removing the filling film applied after the substrate washing; and applying a resist underlayer film for multilayer resist process. This can contribute to rationalization of semiconductor manufacturing processes. Alternatively, in drying processes not using a material for forming a filling film for inhibiting semiconductor substrate pattern collapse, such as drying method using 2-propanol, the inventive material for forming a filling film for inhibiting semiconductor substrate pattern collapse may be used instead and can omit the application in the step of applying a resist underlayer film for multilayer resist process, so that the present invention can contribute to the rationalization of semiconductor processes.

Furthermore, in the present invention, after the cured filling film is removed from the semiconductor substrate, metal impurity amount on the surface of the semiconductor substrate is preferably 2.0×10E⁺¹⁰ atoms/cm² or less.

As described above, the amount of metal impurity contained in the inventive material for forming a filling film for inhibiting semiconductor substrate pattern collapse is so small that the metal impurity amount on the substrate surface is small after the filling film is removed from the substrate pattern. Thus, the inventive material is less likely to lower device yield or reliability, and is suitable in a semiconductor-substrate-pattern-collapse inhibitory process for inhibiting fall or collapse which would otherwise occur in drying up a washing liquid after the substrate pattern washing.

Furthermore, in the present invention, the washing liquid or rinsing liquid is preferably a liquid containing any one or more of water, a water-soluble alcohol, and a fluorine compound.

Selecting such a washing liquid or rinsing liquid can ensure high affinity to the material for forming a filling film for inhibiting semiconductor substrate pattern collapse, allowing efficient replacement.

### ADVANTAGEOUS EFFECTS OF INVENTION

As described above, the inventive material for forming a filling film for inhibiting semiconductor substrate pattern collapse and the inventive method for treating a semiconductor substrate by using this material are excellent in performance of substrate-pattern-collapse inhibition after the filling film is removed because the filling property for a pattern substrate with high aspect ratio is high. The inventive material and method are widely applicable to fine structure patterns which are susceptible to substrate pattern collapse, for example, line-and-space pattern in FinFet structure of Logic, line-and-space pattern and island pattern in STI structure of DRAM, pillar pattern in capacitor structure of DRAM, hole pattern and slit pattern in cell structure of 3D-NAND, etc. Moreover, since the metal impurity amount on the semiconductor substrate surface is small after the filling film removal, the present invention is quite useful in the process of washing and drying a substrate. Thus, the inventive material for forming a filling film for inhibiting semiconductor substrate pattern collapse and method for treating a semiconductor substrate by using this material are suitably employable in semiconductor-substrate-pattern-collapse inhibitory processes for inhibiting fall or collapse which would otherwise occur in drying up a washing liquid or rinsing liquid after the substrate pattern washing, the processes being presumably widely utilized in the future because of higher aspects of substrate patterns along with semiconductor miniaturization.

### BRIEF DESCRIPTION OF DRAWINGS

FIG. 1 is an explanatory diagram illustrating an example of a method for treating a semiconductor substrate by using a material for forming a filling film for inhibiting semiconductor substrate pattern collapse according to the present invention.
FIG. 2 is an explanatory diagram illustrating an example of another method for treating a semiconductor substrate pattern by using the inventive material for forming a filling film for inhibiting semiconductor substrate pattern collapse.
FIG. 3 is an explanatory diagram illustrating exemplary semiconductor-substrate-pattern-collapse inhibitory defects which caused substrate pattern collapses and were compared in Examples of the present invention.
FIG. 4 is an explanatory diagram illustrating a method for evaluating planarizing property in Examples of the present invention.

### DESCRIPTION OF EMBODIMENTS

As noted above, along with miniaturization of semiconductor devices, there have been demands for: a material for forming a filling film for inhibiting semiconductor substrate pattern collapse, the material having high filling property for a pattern substrate with high aspect ratio and excellent performance of inhibiting substrate pattern collapse after filling film removal in a high-aspect-ratio-pattern-substrate collapse inhibitory process following substrate washing; and a method for treating a semiconductor substrate by using the material.

The present inventors have earnestly studied the above problems and consequently verified the effect of inhibiting substrate pattern collapse by filling film formation in a high-aspect-ratio-pattern-substrate collapse inhibitory process after substrate washing. The inventors have found that when a material for forming a filling film for inhibiting semiconductor substrate pattern collapse mainly contains a polymer with a particular structure and a residual-solvent removal promoter, this material and a method for treating a semiconductor substrate by using this material are very effective in eliminating voids, which would cause substrate pattern collapse, in the filling film. This finding has led to the completion of the present invention.

Specifically, the present invention is a material for forming a filling film for inhibiting semiconductor substrate pattern collapse, comprising:
(A) a polymer having a structural unit shown by the following general formula (1);
(B) a residual-solvent removal promoter containing a compound shown by the following general formula (2); and
(C) an organic solvent,

wherein a ratio Mw/Mn of a weight-average molecular weight Mw and a number-average molecular weight Mn of the polymer (A) in terms of polystyrene by a gel permeation chromatography method is 2.50≤Mw/Mn≤9.00,
the residual-solvent removal promoter (B) is contained in an amount of 0.1 to 40 parts by mass based on 100 parts by mass of the polymer (A), and
the material for forming a filling film for inhibiting semiconductor substrate pattern collapse comprises no acid generator, 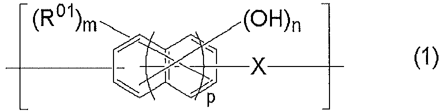 wherein R⁰¹ represents a saturated or unsaturated monovalent organic group having 1 to 30 carbon atoms; X represents a divalent organic group having 1 to 30 carbon atoms; "m" represents an integer of 0 to 5, "n" represents an integer of 1 to 6, and m+n is an integer of 1 or more and 6 or less; and "p" represents 0 or 1, 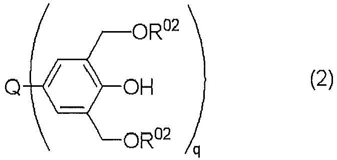 wherein Q represents a single bond, or a hydrocarbon group with a valency of "q" having 1 to 20 carbon atoms; R⁰² represents a hydrogen atom or a methyl group; and "q" represents an integer of 1 to 5.

Hereinafter, embodiments of the present invention will be described, but the present invention is not limited to the following embodiments. That is, it should be understood that based on common knowledge of those skilled in the art, the following embodiments may be appropriately altered or modified, for example, and such embodiments also fall within the scope of the present invention.

### <Material for Forming Filling Film for Inhibiting Semiconductor Substrate Pattern Collapse>

The inventive material for forming a filling film for inhibiting semiconductor substrate pattern collapse contains (A) a polymer having a structural unit shown by the general formula (1), (B) a residual-solvent removal promoter containing a compound shown by the general formula (2), and (C) an organic solvent. The ratio Mw/Mn of the weight-average molecular weight Mw and the number-average molecular weight Mn of the polymer (A) in terms of polystyrene determined by a gel permeation chromatography method is 2.50≤Mw/Mn≤9.00. The content of the residual-solvent removal promoter (B) is 0.1 to 40 parts by mass based on 100 parts by mass of the polymer (A). The material for forming a filling film for inhibiting semiconductor substrate pattern collapse contains no acid generator. This material for forming a filling film for inhibiting semiconductor substrate pattern collapse is suitably used in such a treatment method that after a step of washing a semiconductor substrate having an uneven pattern formed on a surface thereof, the washing liquid or rinsing liquid held in recesses is replaced with the material to fill the recesses, and the filling film thus formed is removed by dry etching before a drying step.

The material for forming a filling film for inhibiting semiconductor substrate pattern collapse is desirably used to fill gaps in a substrate pattern. Specifically, after a substrate having a surface with an uneven pattern formed thereon is washed, for example, the unevenly-patterned surface of the substrate is coated with the material for forming a filling film for inhibiting semiconductor substrate pattern collapse. As a result, the liquid such as washing liquid or rinsing liquid on the substrate is replaced with the material for forming a filling film for inhibiting semiconductor substrate pattern collapse, and a film filling the gaps in the recessed pattern (filling film) is formed. In this method, such a liquid as washing liquid or rinsing liquid can be removed without a drying operation for the liquid. This method thereby inhibits pattern collapse that occurs when the gas-liquid interface passes through side surfaces of the substrate pattern. The filling film can be removed from the top of the substrate as necessary by dry etching or the like.

The material for forming a filling film for inhibiting semiconductor substrate pattern collapse contains (A) a polymer, (B) a residual-solvent removal promoter, and (C) a solvent, but no acid generator. This composition enables formation of a filling film excellent in substrate pattern collapse inhibition. Why the material for forming a filling film for inhibiting semiconductor substrate pattern collapse exhibits this effect by having the configuration is not exactly clear, but the reason can be assumed as follows, for example.

Specifically, since the material for forming a filling film for inhibiting semiconductor substrate pattern collapse employs the polymer (A) having a structural unit shown by the general formula (1), a high-molecular-weight compound can be produced by heating that causes crosslinking reaction with the residual-solvent removal promoter (B). As a result, heat resistance can be imparted to the filling film. Such a filling film for inhibiting substrate pattern collapse suppresses the thermal melting and readily maintains the strength, even if part or all of the filling film is heated during the removal from the substrate by dry etching or the like. Thus, this filling film can be surely removed by dry etching or the like, while inhibiting the substrate pattern collapse. Meanwhile, if a substrate pattern has a larger aspect ratio, this makes it difficult to remove the residual solvent from the filling film filling recesses. Heating removes the residual solvent possessed by the polymer (A), with which the recesses are filled, but curing of the filling film also progresses simultaneously. Consequently, the residual solvent entrapped in the cured film foams, so that voids are likely formed. The composition containing only a particular polymer and a solvent known from the prior art WO 2018/074535 A1 has problems that the residual solvent possessed by the particular polymer foams in the filling film for a high-aspect-ratio-pattern substrate, forming voids in the filling film.

In contrast, the residual-solvent removal promoter (B) is added in the inventive material for forming a filling film for inhibiting semiconductor substrate pattern collapse, and facilitates removal of a residual solvent held by the polymer (A) from the filling film, enabling filling film formation without voids. The mechanism of facilitating the removal of the residual solvent possessed by the polymer (A) is presumably that high-dimensional crosslinking of the polymer (A) and the compound of the residual-solvent removal promoter (B) lowers the affinity between the polymer (A) and the solvent (C), making the solvent (C) easily evaporate. On the other hand, in the composition characterized by containing a particular polymer, a particular crosslinking agent, an acid generator, and a solvent known from the prior art JP 6550760 B, the particular polymer has insufficient residual-solvent removability, and voids are likely formed in a filling film when a high-aspect-ratio-pattern substrate is filled. Hence, as the polymer structure, the structure of the polymer having a structural unit shown by the general formula (1) of the present invention is preferable.

Meanwhile, if an acid generator is incorporated into a material for forming a filling film for inhibiting semiconductor substrate pattern collapse, the catalytic action by acid to be generated causes the crosslinking reaction to acceleratingly progress between the polymer (A) and the residual-solvent removal promoter (B), so that the resulting filling film rapidly contracts, and physical stress strongly works on the substrate pattern, making the substrate pattern easily curved. Further, the curing of the filling film is completed before the residual solvent removal is completed, so that the residual solvent entrapped in the cured film foams, and voids are likely formed. Since the inventive material for forming a filling film for inhibiting semiconductor substrate pattern collapse does not contain an acid generator, moderate crosslinking reaction progresses between the polymer (A) and the residual-solvent removal promoter (B). This promotes the removal of the residual solvent and suppresses the stress on the substrate pattern, making it easy to keep the strength. Thus, a material for forming a filling film for inhibiting semiconductor substrate pattern collapse which is excellent in filling property can be provided.

The material for forming a filling film for inhibiting semiconductor substrate pattern collapse is capable of forming a coating film having a film thickness of at least 50 nm to at most 6000 nm, by adjusting the solid content concentration of the material for forming a filling film for inhibiting semiconductor substrate pattern collapse. Consequently, the coating film is useful as a filling film for various fine structures that are susceptible to substrate pattern collapse. Examples of the fine structures substrate pattern collapse include line-and-space pattern in FinFet structure of Logic, line-and-space pattern and island pattern in STI structure of DRAM, pillar pattern in capacitor structure of DRAM, hole pattern and slit pattern in cell structure of 3D-NAND, etc.

### [(A) Polymer]

The polymer (A) incorporated in the inventive material for forming a filling film for inhibiting semiconductor substrate pattern collapse has a structural unit shown by the following general formula (1). 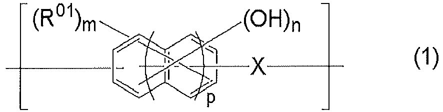 In the general formula (1), R⁰¹ represents a saturated or unsaturated monovalent organic group having 1 to 30 carbon atoms. X represents a divalent organic group having 1 to 30 carbon atoms. "m" represents an integer of 0 to 5, "n" represents an integer of 1 to 6, and m+n is an integer of 1 or more and 6 or less. "p" represents 0 or 1.

The use of the polymer having a structural unit shown by the general formula (1) makes it possible to provide a material for forming a filling film for inhibiting semiconductor substrate pattern collapse which is excellent in replacement likeliness (affinity) with respect to washing liquid or rinsing liquid, flowability, and affinity to substrate.

Examples of the saturated or unsaturated monovalent organic group having 1 to 30 carbon atoms represented by R⁰¹ in the general formula (1) include monovalent saturated hydrocarbon groups, such as a methyl group, an ethyl group, an n-propyl group, an i-propyl group, an n-butyl group, an i-butyl group, a sec-butyl group, a tert-butyl group, an n-pentyl group, an iso-pentyl group, a sec-pentyl group, and a tert-pentyl group; monovalent unsaturated open-chain hydrocarbon groups, such as an ethenyl group, a propenyl group, a butenyl group, a pentenyl group, an ethynyl group, and a propynyl group; monocyclic saturated cyclic hydrocarbon groups, such as a cyclobutyl group, a cyclopentyl group, a cyclohexyl group, a cycloheptyl group, and a cyclooctyl group; monovalent monocyclic unsaturated cyclic hydrocarbon groups, such as a cyclobutenyl group, a cyclopentenyl group, and a cyclohexenyl group; monovalent polycyclic cyclic hydrocarbon groups, such as a norbornyl group and an adamantyl group; monovalent aromatic hydrocarbon groups, such as a phenyl group, a methylphenyl group, a naphthyl group, a methylnaphthyl group, an anthryl group, and a methylanthryl group; etc.

The examples of the organic group represented by R⁰¹ further include alkoxy groups, such as a methoxy group, an ethoxy group, an n-propoxy group, an i-propoxy group, an n-butoxy group, an i-butoxy group, a sec-butoxy group, a t-butoxy group, an n-pentyloxy group, and an n-hexyloxy group; alkoxycarbonyl groups, such as a methoxycarbonyl group, an ethoxycarbonyl group, an n-propoxycarbonyl group, an i-propoxycarbonyl group, an n-butoxycarbonyl group, an i-butoxycarbonyl group, a sec-butoxycarbonyl group, a t-butoxycarbonyl group, an n-pentyloxycarbonyl group, and an n-hexyloxycarbonyl group; etc.

These saturated hydrocarbon groups, unsaturated open-chain hydrocarbon groups, monocyclic saturated cyclic hydrocarbon groups, monocyclic unsaturated cyclic hydrocarbon groups, polycyclic cyclic hydrocarbon groups, aromatic hydrocarbon groups, alkoxy groups, alkoxycarbonyl groups, and the like may have some or all of hydrogen atoms substituted. Examples of such substituents include halogen atoms, such as a fluorine atom, a chlorine atom, a bromine atom, and an iodine atom; a hydroxyl group, a cyano group, a carboxy group, a nitro group, an amino group, an alkoxy group, an alkoxycarbonyl group, an acyl group, an alkoxycarbonyloxy group, and an aryl group; aliphatic heterocyclic groups, such as a lactone group; aromatic heterocyclic groups, such as a furyl group and a pyridyl group; etc.

The organic group represented by R⁰¹ is preferably a methyl group from the viewpoint of the raw material availability.

Examples of the divalent organic group having 1 to 30 carbon atoms represented by X in the general formula (1) include alkanediyl groups, such as a methylene group, an ethanediyl group, a propanediyl group, a butanediyl group, a pentanediyl group, a hexanediyl group, an octanediyl group, and a decanediyl group; monocyclic cycloalkanediyl groups, such as a cyclopropanediyl group, a cyclobutanediyl group, a cyclopentanediyl group, a cyclohexanediyl group, a cycloheptanediyl group, a cyclooctanediyl group, a cyclodecanediyl group, a methylcyclohexanediyl group, and an ethylcyclohexanediyl group; polycyclic cycloalkanediyl groups, such as a bicyclo[2.2.1]heptanediyl group, a bicyclo[2.2.2]octanediyl group, a tricyclo[5.2.1.0^{2,6}]decanediyl group (dicyclopentylene group), a tricyclo[3.3.1.1^{3,7}]decanediyl group, a tetracyclo[6.2.1.1^{3,6}.0^{2,7}]dodecanediyl group, and an adamantanediyl group; arenediyl groups, such as a phenylene group and a naphthylene group; etc.

The X may represent an alkanediyloxy group, and examples thereof include groups which are combinations between the aforementioned alkanediyl groups and an oxygen atom; etc. Moreover, the X may represent a cycloalkanediyloxy group, and examples thereof include groups which are combinations between the aforementioned cycloalkanediyl groups and an oxygen atom; etc.

These alkanediyl groups, cycloalkanediyl groups, alkanediyloxy groups, cycloalkanediyloxy groups, arenediyl groups, and the like may have some or all of hydrogen atoms substituted. Examples of such substituents include the same groups exemplified as the substituent which the organic group represented by R⁰¹ may have; etc.

Examples of the organic group represented by X include groups represented by the following formulae, etc. 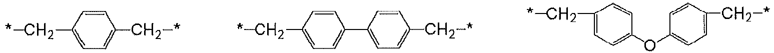 In the formulae, * represents a bonding arm.

X is preferably a methylene group from the viewpoint of the raw material availability.

Specific examples of the polymer (A) having a structural unit shown by the general formula (1) include the following, but are not limited thereto. From the viewpoint of the raw material availability, (AX-1) or (AX-3) is preferable, and (AX-3) is particularly preferable.

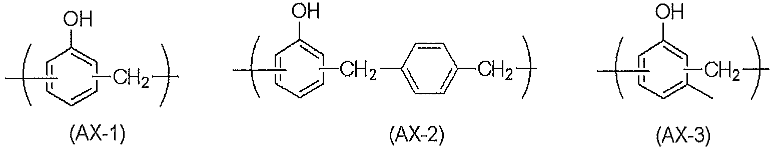

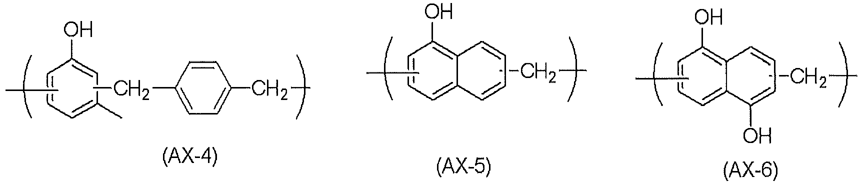

The weight-average molecular weight Mw and number-average molecular weight Mn of the polymer (A) determined in terms of polystyrene by a gel permeation chromatography method satisfy a ratio Mw/Mn of 2.50≤Mw/Mn≤9.00, preferably 3.00≤Mw/Mn≤8.00.

If the Mw/Mn of the polymer (A) used in the material for forming a filling film for inhibiting semiconductor substrate pattern collapse is outside these ranges, the flowability of the filling film is lowered, and it becomes impossible to provide a material for forming a filling film for inhibiting semiconductor substrate pattern collapse which has excellent filling property even in combination with the residual-solvent removal promoter (B).

The weight-average molecular weight Mw of the polymer (A) determined in terms of polystyrene by a gel permeation chromatography method is preferably 1,500≤Mw≤20,000, further preferably 3,000≤Mw≤15,000, particularly preferably 4,000≤Mw≤9,000.

Controlling the Mw of the polymer (A) used in the material for forming a filling film for inhibiting semiconductor substrate pattern collapse within such ranges makes it possible to enhance the flowability of the filling film, and to provide a material for forming a filling film for inhibiting semiconductor substrate pattern collapse which has excellent filling property in combination with the residual-solvent removal promoter (B). It is also possible to form a filling film excellent in film thickness uniformity and having small sublimation amount.

The polymer (A) may include a polymer having a structural unit shown by the following general formula (3) in addition to the structural unit of the formula (1). 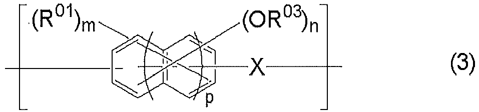 In the general formula (3), R⁰³ represents a saturated or unsaturated monovalent organic group having 1 to 30 carbon atoms. "m" represents an integer of 0 to 5, "n" represents an integer of 1 to 6, and m+n is an integer of 1 or more and 6 or less. "p" represents 0 or 1. R⁰¹ and X are as defined above.

Examples of the saturated or unsaturated monovalent organic group having 1 to 30 carbon atoms represented by R⁰³ in the general formula (3) include those exemplified as R⁰¹.

Further, as a preferable form of the general formula (3), the polymer may have a structural unit in which R⁰³ is an alkyl group having 1 to 30 carbon atoms, or any of structures shown in the following general formula (4). 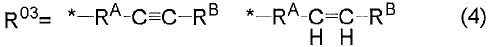 In the general formula (4), * represents an attachment point to an oxygen atom. R^{A} represents a divalent organic group having 1 to 10 carbon atoms optionally having a substituent. R^{B} represents a hydrogen atom or a monovalent organic group having 1 to 10 carbon atoms optionally having a substituent.

Examples of the divalent organic group having 1 to 10 carbon atoms represented by R^{A} in the general formula (4) include alkanediyl groups, such as a methylene group, an ethanediyl group, a propanediyl group, a butanediyl group, a pentanediyl group, a hexanediyl group, an octanediyl group, and a decanediyl group; arenediyl groups, such as a benzenediyl group, a methylbenzenediyl group, and a naphthalenediyl group; etc.

Examples of the monovalent organic group having 1 to 10 carbon atoms represented by R^{B} in the general formula (4) include alkyl groups, such as a methyl group, an ethyl group, an n-propyl group, an i-propyl group, an n-butyl group, an i-butyl group, a sec-butyl group, a t-butyl group, an n-pentyl group, an n-hexyl group, an n-octyl group, and an n-decyl group; aryl groups, such as a phenyl group, a tolyl group, a xylyl group, a mesityl group, and a naphthyl group; etc.

These alkanediyl groups, arenediyl groups, alkyl groups, aryl groups, and the like may have some or all of hydrogen atoms substituted. Examples of such substituents include the same groups exemplified as the substituent which the organic group represented by R⁰¹ may have; etc.

Particularly preferable examples of R⁰³ can include structures shown below. Having such structures makes the flowability favorable, enhances the filling property, and can provide a material for forming a filling film for inhibiting semiconductor substrate pattern collapse, the material enabling filling film formation with small residual solvent amount. Moreover, the heat resistance and film formability become favorable, sublimation products are suppressed during heat curing, contamination of the apparatus due to the sublimation products is suppressed, and coating defect can be suppressed. 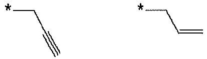 In the formulae, * represents an attachment point to the oxygen atom.

Specific examples of the polymer having a structural unit shown by the general formula (3) include the following, but are not limited thereto. From the viewpoint of the raw material availability, (AY-1) or (AY-3) is preferable, and (AY-3) is particularly preferable.

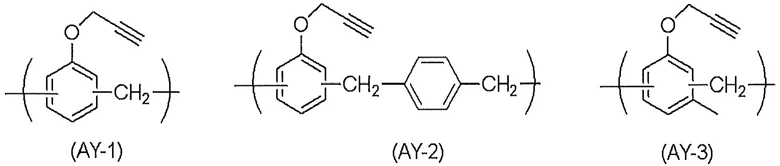

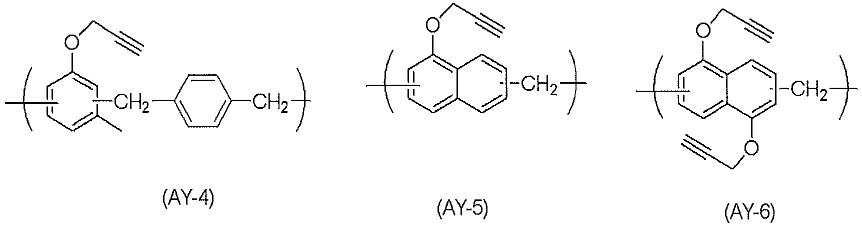

The polymer having a structural unit of the general formula (3) is contained in an amount satisfying relations of preferably a+b=100 and b≤90, further preferably b≤70, where "a" represents a proportion of the general formula (1), and "b" represents a proportion of the general formula (3).

Controlling the proportion in the polymer with the general formula (3) within such ranges can enhance the performance of filling a pattern substrate while ensuring the affinity to washing liquid or rinsing liquid. It is also possible to reduce cracking in the filling film which would otherwise be caused by insufficient adhesiveness between the pattern substrate and the filling film.

Further, as described above, equivalent compositions can also be produced not only by mixing two types of the polymer in desired proportion, but also by controlling proportions of substituents in one type of the polymer. In this case, an equivalent composition can be prepared by using a polymer shown by the following general formula (5) while controlling a proportion of structures constituting R⁰⁴. Specifically, a relation of a+b=100 is satisfied, where "a" represents a proportion of hydrogen atoms in the structures constituting R⁰⁴, and "b" represents a proportion of an alkyl group having 1 to 10 carbon atoms or a structure shown by the general formula (4); in this case, the proportions preferably satisfy a relation of b≤90. Further preferable examples of the ratioinclude a relation of b≤70. 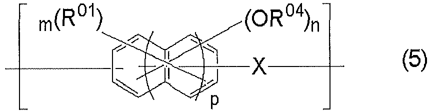 In the general formula (5), R⁰⁴ represents a hydrogen atom, an alkyl group having 1 to 10 carbon atoms, or any of the structures shown in the general formula (4). A relation of a+b=100 is satisfied, where "a" represents a proportion of hydrogen atoms, and "b" represents a proportion of the alkyl group having 1 to 10 carbon atoms or the structures shown in the general formula (4) among the structures constituting R⁰⁴. "m", "n", m+n, "p", R⁰¹, and X are as defined above.

In the material for forming a filling film for inhibiting semiconductor substrate pattern collapse, the lower limit of the content of the polymer (A) is preferably 0.1 mass%, more preferably 3 mass%, further preferably 5 mass%. Meanwhile, the upper limit of the content is preferably 50 mass%, more preferably 40 mass%, further preferably 35 mass%.

Setting the content of the polymer (A) within these ranges enables formation of a coating film having a film thickness of at least 50 nm to at most 6000 nm from the material for forming a filling film for inhibiting semiconductor substrate pattern collapse. This is useful as a filling film for various fine structures that are likely to cause substrate pattern collapse. Examples of the fine structures that are likely to cause substrate pattern collapse include line-and-space pattern in FinFet structure of Logic, line-and-space pattern and island pattern in STI structure of DRAM, pillar pattern in capacitor structure of DRAM, hole pattern and slit pattern in cell structure of 3D-NAND, etc.

A metal impurity amount in the polymer (A) in mass ratio is preferably 100 ppb or less, more preferably 10 ppb or less, further preferably 5 ppb or less.

The metal is selected from preferably Li, Na, Mg, Al, K, Ca, Cr, Mn, Fe, Ni, Cu, Zn, Sn, Pb, Au, Co, Ti, Ag, Cd, V, As, Ba, and W, more preferably Na, Mg, K, Ca, Mn, Fe, Ni, Cu and Ti. In the polymer, the metal impurity of these elements may be present in any form, such as metal fine particle, ion, colloid, complex, oxide, and nitride, and may be dissolved or undissolved.

Controlling each metal impurity within the ranges can reduce the metal impurity amount on the substrate surface after the removal by dry etching of the filling film filling an uneven pattern, and can prevent the device yield and reliability from lowering.

The kind and content of metal in the polymer can be measured by ICP-MS method (Inductively Coupled Plasma-Mass Spectrometry), etc.

### [(B) Residual-Solvent Removal Promoter]

The residual-solvent removal promoter (B) contains a compound shown by the following general formula (2). Thereby, the crosslinking reaction with the polymer (A) in the filling film progresses and facilitates the removal of a residual solvent held by the polymer (A) from the filling film, enabling formation of void-free filling film. Moreover, the compound shown by the following general formula (2) has sufficient crosslinking rate. For this reason, the present invention contains no acid generator. Herein, the term "acid generator" refers to an additive that generates an acid by heat or light. Examples thereof include onium salt compounds, such as sulfonium salt and iodonium salt; etc. If an acid generator is contained, the catalytic action of the acid causes the crosslinking reaction of the polymer (A) and the residual-solvent removal promoter (B) to acceleratingly progress. Thereby, the filling film to be formed rapidly contracts, and physical stress strongly works on the substrate pattern, so that the substrate pattern may curve. Moreover, since the curing of the filling film ends before the residual solvent is completely removed, voids may be formed by foaming of the residual solvent entrapped in the cured film. 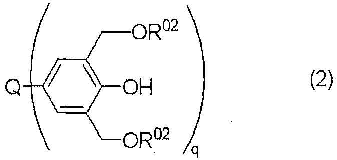 In the general formula (2), Q represents a single bond, or a hydrocarbon group with a valency of "q" having 1 to 20 carbon atoms. R⁰² represents a hydrogen atom or a methyl group. "q" represents an integer of 1 to 5.

In the general formula (2), Q is a single bond, or a hydrocarbon group having a valency of "q" and 1 to 20 carbon atoms. "q" is an integer of 1 to 5, more preferably 2 or 3. In the case where Q is a hydrocarbon group having a valency of "q" and 1 to 20 carbon atoms, Q is a hydrocarbon group with a valency of "q" corresponding to a hydrocarbon having 1 to 20 carbon atoms from which "q" hydrogen atoms are excluded. In this case, specific examples of the hydrocarbon having 1 to 20 carbon atoms include methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane.

In the general formula (2), R⁰² is a hydrogen atom or a methyl group, preferably a methyl group.

Specific examples of the compound shown by the general formula (2) include the following compounds, but are not limited thereto. In the following formulae, R⁰² is as defined above. Preferably, q=3 and R⁰² is a methyl group from the viewpoints of curability, film thickness uniformity enhancement, and residual solvent removability. Particularly, triphenolmethane, triphenolethane, 1,1,1-tris(4-hydroxyphenyl)ethane, and tris(4-hydroxyphenyl)-1-ethyl-4-isopropylbenzene that are subjected to hexamethoxymethylation are preferable.

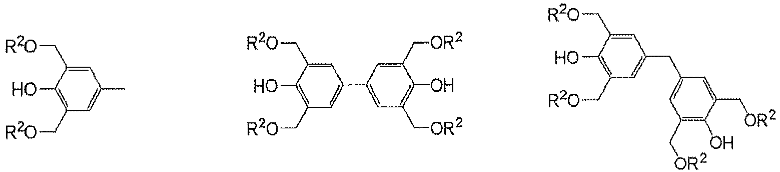

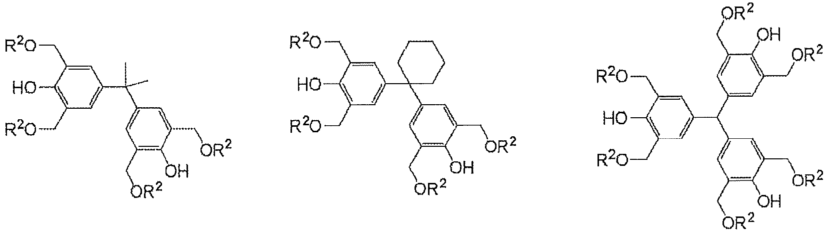

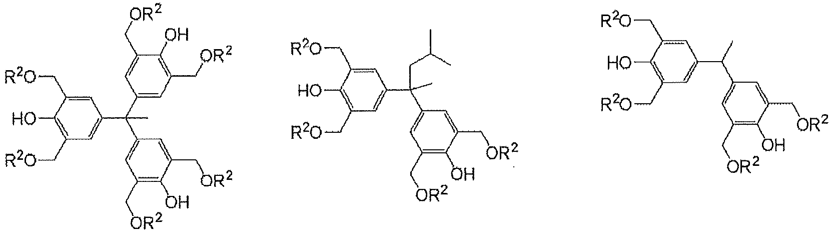

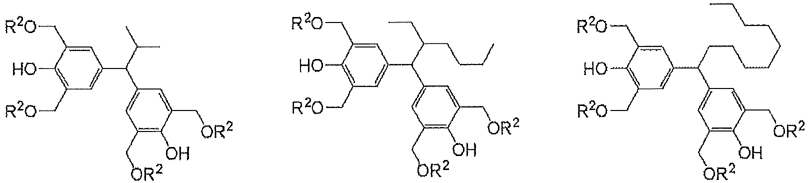

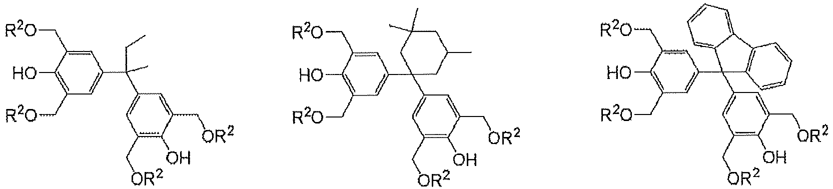

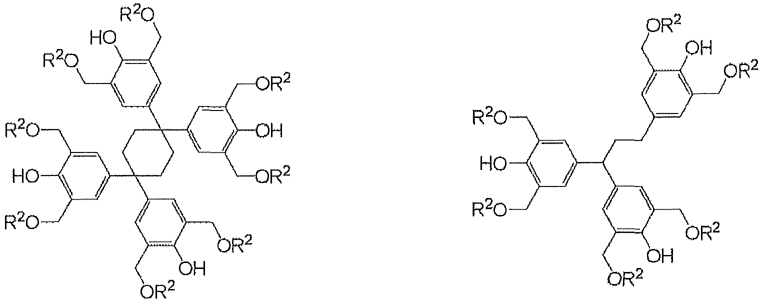

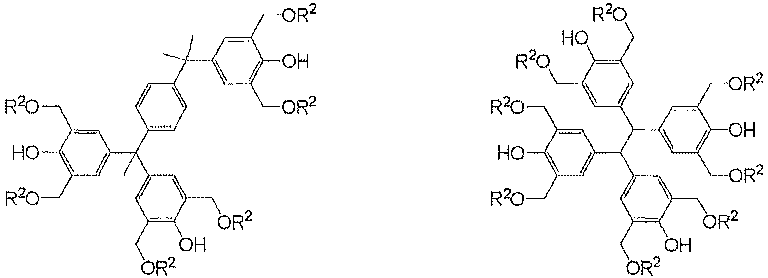

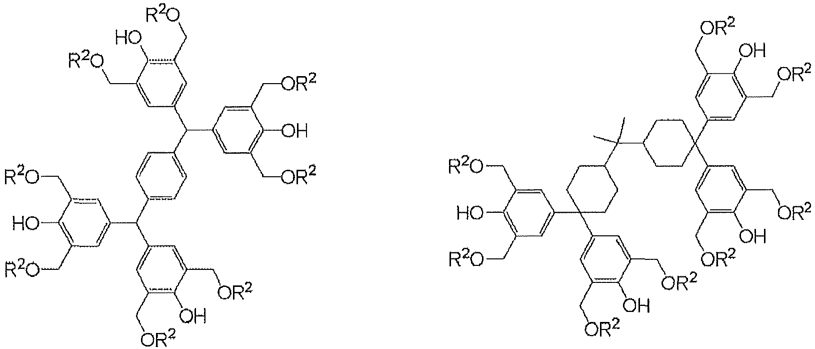

One kind of the residual-solvent removal promoter (B) can be used singly, or two or more kinds thereof can be used in combination. The residual-solvent removal promoter (B) is contained in an amount of 0.1 mass% to 40 mass%, preferably 10 mass% to 30 mass%, based on 100 parts by mass of the polymer (A). If the residual-solvent removal promoter (B) is added in an amount of less than 0.1 mass%, it does not have sufficient crosslinking reactivity with the polymer (A) and cannot promote the removal of the residual solvent possessed by the polymer (A) in the filling film. Meanwhile, if the amount of the residual-solvent removal promoter (B) added exceeds 40 mass%, the crosslinking reaction takes place slowly between the polymer (A) and the residual-solvent removal promoter (B), so that sublimation products are generated and the film thickness uniformity is degraded.

### [(C) Organic Solvent]

The material for forming a filling film for inhibiting semiconductor substrate pattern collapse contains (C) an organic solvent. Examples of the organic solvent (C) include ketone-based solvents, amide-based solvents, ether-based solvents, ester-based solvents, mixture solvents, thereof, etc. The organic solvent (C) is not particularly limited, as long as it dissolves the polymer (A) and the residual-solvent removal promoter (B), as well as, if contained, (D) a surfactant, and so forth to be described below. Specifically, solvents having a boiling point of less than 180°C disclosed in paragraphs [0091] to [0092] of JP 2007-199653 A, and similar other solvents can be used. Particularly, it is preferable to use propylene glycol monomethyl ether acetate, propylene glycol monomethyl ether, 2-heptanone, cyclopentanone, cyclohexanone, or a mixture containing two or more of these. The organic solvent is blended in an amount of preferably 50 to 1,800 parts, more preferably 150 to 1,500 parts, based on 100 parts by mass of the polymer (A).

Such a material for forming a filling film for inhibiting semiconductor substrate pattern collapse is applicable by spin coating, so that a filling film for inhibiting semiconductor substrate pattern collapse has film thickness uniformity and high filling property.

Further, the inventive material for forming a filling film for inhibiting semiconductor substrate pattern collapse can contain as the organic solvent a high-boiling-point solvent in addition to the aforementioned solvent having a boiling point of lower than 180°C (i.e., a mixture of a solvent having a boiling point of lower than 180°C and a solvent having a boiling point of 180°C or higher). The high-boiling-point solvent is preferably one or more organic solvents each having a boiling point of 180°C or higher. The high-boiling-point solvent is not particularly limited to hydrocarbons, alcohols, ketones, esters, ethers, chlorinated solvents, and so forth as long as the high-boiling-point solvent is capable of dissolving the polymer and/or residual-solvent removal promoter. Specific examples of the high-boiling-point solvent include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butylmethyl ether, triethylene glycol dimethyl ether, triethylene glycol monomethyl ether, triethylene glycol-n-butyl ether, triethylene glycol butylmethyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, dihexyl malonate, diethyl succinate, dipropyl succinate, dibutyl succinate, dihexyl succinate, dimethyl adipate, diethyl adipate, dibutyl adipate, and the like. One of these or a mixture thereof may be used.

The boiling point of the high-boiling-point solvent(s) may be selected appropriately according to the temperature at which the filling film is heated. The boiling point of the high-boiling-point solvent(s) to be added is preferably 180°C to 300°C, more preferably 200°C to 300°C. Such boiling points make the evaporation rate at baking (heating), and sufficient thermal flowability can be achieved. Moreover, the high-boiling-point solvent does not remain in the film after baking; thus, the film physical properties, such as etching resistance, are not adversely affected.

When the high-boiling-point solvent is used, the high-boiling-point solvent is blended in an amount of preferably 1 to 50 parts by mass based on 100 parts by mass of the solvent having a boiling point of lower than 180°C. Such blend amount can provide sufficient thermal flowability during baking, the high-boiling-point solvent does not remain in the film, and deterioration of the film physical properties such as etching resistance is prevented.

With such a material for forming a filling film for inhibiting semiconductor substrate pattern collapse, the material for forming a filling film for inhibiting semiconductor substrate pattern collapse has flowability by the addition of the high-boiling-point solvent, so that the material for forming a filling film for inhibiting semiconductor substrate pattern collapse also has high filling property.

### [(D) Surfactant]

To the inventive material for forming a filling film for inhibiting semiconductor substrate pattern collapse, (D) a surfactant can be added in order to enhance the coating property in spin coating. As the surfactant, for example, those disclosed in [0142] to [0147] of JP 2009-269953 A can be used. Examples thereof include nonionic surfactants, fluorine-based surfactants, etc. When a surfactant is added, the surfactant is added in an amount of preferably 0.01 to 10 parts, more preferably 0.05 to 5 parts, based on 100 parts of the polymer.

### [Metal Impurity Amount]

Preferably, the material for forming a filling film for inhibiting semiconductor substrate pattern collapse contains metal impurity as little as possible from the viewpoint of reducing contamination on the substrate pattern. The metal impurity amount in the material for forming a filling film for inhibiting semiconductor substrate pattern collapse is preferably 10 ppb or less, more preferably 5 ppb or less, further preferably 3 ppb or less, particularly preferably 1 ppb or less, in mass ratio. Controlling the impurity amount of each metal within these ranges makes it possible to reduce the metal impurity amount on the substrate surface after the filling film filling an uneven pattern is removed by dry etching.

The metal is one or more selected from preferably Li, Na, Mg, Al, K, Ca, Cr, Mn, Fe, Ni, Cu, Zn, Sn, Pb, Au, Co, Ti, Ag, Cd, V, As, Ba, and W, more preferably Na, Mg, K, Ca, Mn, Fe, Ni, Cu and Ti. In the material for forming a filling film for inhibiting semiconductor substrate pattern collapse, the metal impurity of each element may be present in any form, such as metal fine particle, ion, colloid, complex, oxide, and nitride, and may be dissolved or undissolved.

Controlling the impurity amount of each metal within the above ranges makes it possible to reduce the metal impurity amount on the substrate surface after the removal by dry etching of the filling film filling an uneven pattern, and to prevent the device yield and reliability from lowering.

After the filling film filling an uneven pattern is removed by dry etching, the metal impurity amount on the substrate surface is preferably 2.0×10E⁺¹⁰ atoms/cm² or less, more preferably 1.0×10E⁺¹⁰ atoms/cm² or less. The metal content on the substrate surface after the filling-film removal can be measured with a system utilizing Expert VPD-ICP-MS manufactured by IAS Inc., for example.

### [Production Method of Material for Forming Filling Film for Inhibiting Semiconductor Substrate Pattern Collapse]

The material for forming a filling film for inhibiting semiconductor substrate pattern collapse can be produced by: mixing the polymer (A), the residual-solvent removal promoter (B), the organic solvent (C), and optional component(s) to be blended as necessary; and filtering the obtained solution through a filter having a pore size of about 0.02 µm, for example. The lower limit of the solid content concentration of the material for forming a filling film for inhibiting semiconductor substrate pattern collapse is preferably 0.1 mass%, more preferably 3 mass%, further preferably 5 mass%. The upper limit of the solid content concentration is preferably 50 mass%, more preferably 40 mass%, further preferably 35 mass%. Here, the "solid content" of the material for forming a filling film for inhibiting semiconductor substrate pattern collapse refers to components other than the organic solvent (C).

When the material for forming a filling film for inhibiting semiconductor substrate pattern collapse has a solid content concentration within the ranges, a coating film having a film thickness of at least 50 nm to at most 6000 nm can be formed from the material for forming a filling film for inhibiting semiconductor substrate pattern collapse. This film is useful as a filling film for various fine structures susceptible to substrate pattern collapse. Examples of the fine structures susceptible to substrate pattern collapse include line-and-space pattern in FinFet structure of Logic, line-and-space pattern and island pattern in STI structure of DRAM, pillar pattern in capacitor structure of DRAM, hole pattern and slit pattern in cell structure of 3D-NAND, etc.

Additionally, the obtained material for forming a filling film for inhibiting semiconductor substrate pattern collapse is preferably further filtered through a nylon filter (for example, a filter using a nylon 66 film as a filtration medium), an ion exchange filter, or a filter utilizing adsorption action by zeta potential. The filtration with a nylon filter, an ion exchange filter, or a filter utilizing adsorption action by zeta potential as described above enables easy and reliable reduction of the metal content in the material for forming a filling film for inhibiting semiconductor substrate pattern collapse, and the material for forming a filling film for inhibiting semiconductor substrate pattern collapse is obtained with little metal content at low cost. Note that the metal content of the material for forming a filling film for inhibiting semiconductor substrate pattern collapse can also be reduced, for example, through purification by known methods: chemical purification methods, such as water washing and liquid-liquid extraction; combination of a chemical purification method with a physical purification method, such as ultrafiltration and centrifugation; etc.

### <Methods for Treating Semiconductor Substrate>

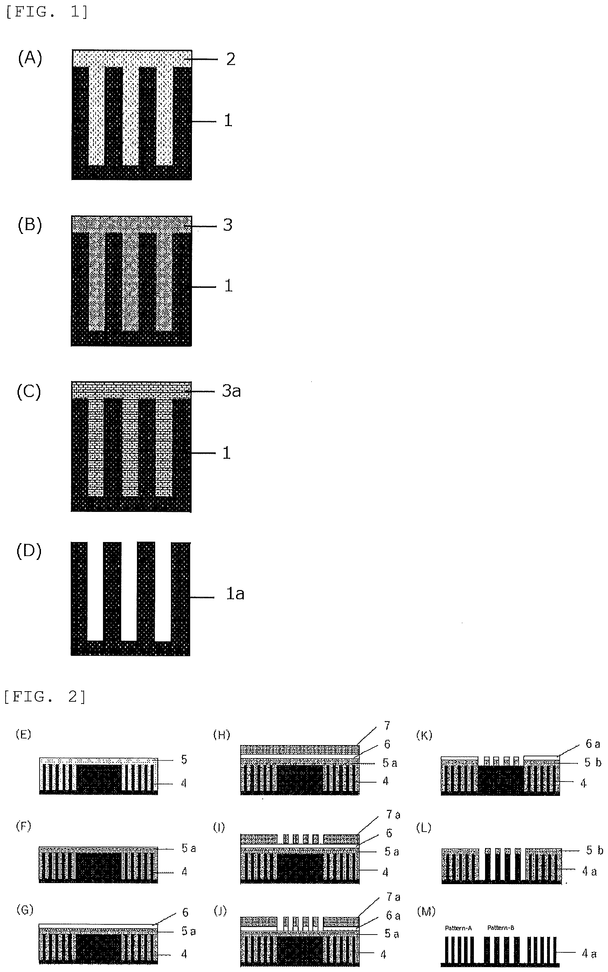

With reference to FIG. 1, description will be given hereinbelow of a specific process for inhibiting pattern collapse of a semiconductor substrate having a high aspect ratio of 5 or more, for example, the process utilizing the inventive material for forming a filling film for inhibiting semiconductor substrate pattern collapse.

A preferable method for treating a semiconductor substrate is a method for treating a semiconductor substrate having an uneven pattern formed on a surface thereof to dry the semiconductor substrate, the method including steps of:
(1) washing the pattern-formed semiconductor substrate 1 with a washing liquid 2, or washing the pattern-formed semiconductor substrate with a washing liquid 2 and then replacing the washing liquid 2 with a rinsing liquid 2 (FIG. 1 (A));
(2) filling the pattern with a filling film 3 in place of the washing liquid 2 or rinsing liquid 2 by using the above-described material for forming a filling film for inhibiting semiconductor substrate pattern collapse (FIG. 1 (B));
(3) curing the filling film 3 by heating at a temperature of 100°C or higher and 600°C or lower for 10 to 600 seconds (cured filling film 3a, FIG. 1 (C)); and
(4) removing the cured filling film 3a from the semiconductor substrate by dry etching (the filling-film removal results in a semiconductor substrate 1a, FIG. 1 (D)).

In a preferable method for treating a semiconductor substrate by using the material for forming a filling film for inhibiting semiconductor substrate pattern collapse, after a wet etching or dry etching step, at least one step selected from a washing step of washing a semiconductor substrate with a washing liquid and a rinsing step of rinsing a semiconductor substrate with a rinsing liquid is performed. Then, the pattern-formed semiconductor substrate is preferably coated with the material for forming a filling film for inhibiting semiconductor substrate pattern collapse, and then dried. In this case, while the washing liquid or rinsing liquid is held on the substrate, the material for forming a filling film for inhibiting semiconductor substrate pattern collapse is further preferably applied to replace the washing liquid or rinsing liquid and form a coating film. Since the method for treating a semiconductor substrate uses the above-described material for forming a filling film for inhibiting semiconductor substrate pattern collapse, the performance of inhibiting semiconductor substrate pattern collapse is excellent and the semiconductor substrate surface has a low metal content after the filling-film removal.

The inventive material for forming a filling film for inhibiting semiconductor substrate pattern collapse is also applicable to a treatment method as shown in FIG. 2, in which the inventive material serves as a resist underlayer film in a multilayer resist process after a semiconductor substrate pattern is filled therewith.

The present invention provides a method for treating a semiconductor substrate having a first uneven pattern formed on a surface thereof to dry the semiconductor substrate and to form a second uneven pattern different from the first uneven pattern in the semiconductor substrate, the method including steps of:
(1) washing the pattern-formed semiconductor substrate (semiconductor substrate 4 having high-aspect-ratio pattern (Pattern-A)) with a washing liquid, or washing the pattern-formed semiconductor substrate with a washing liquid and then replacing the washing liquid with a rinsing liquid;
(2) filling the pattern with a filling film 5 in place of the washing liquid or rinsing liquid by using the above-described material for forming a filling film for inhibiting semiconductor substrate pattern collapse (FIG. 2 (E));
(3) curing the filling film by heating at a temperature of 100°C or higher and 600°C or lower for 10 to 600 seconds (cured filling film 5a, FIG. 2 (F));
(4) forming a silicon-containing resist middle layer film 6 on the cured filling film 5a by using a silicon-containing resist middle layer film material (FIG. 2 (G));
(5) forming a resist upper layer film 7 on the silicon-containing resist middle layer film 6 by using a photoresist composition (FIG. 2 (H));
(6) forming a circuit pattern 7a in the resist upper layer film (FIG. 2 (I));
(7) transferring the pattern to the silicon-containing resist middle layer film (silicon-containing resist middle layer film pattern 6a, FIG. 2 (J)) by etching while using the resist upper layer film having the formed circuit pattern 7a as a mask;
(8) transferring the pattern to the cured filling film (filling film pattern 5b, FIG. 2 (K)) by etching while using the pattern-transferred silicon-containing resist middle layer film as a mask;
(9) forming the second uneven pattern (semiconductor substrate pattern (after Pattern-B formation) 4a, FIG. 2 (L)) different from the first uneven pattern in the semiconductor substrate having the first uneven pattern formed on the surface by etching while using the cured filling film having the transferred pattern as a mask; and
(10) removing the cured filling film from the semiconductor substrate by dry etching (FIG. 2 (M)).

The filling film obtained in this manner by applying the inventive material for forming a filling film for inhibiting semiconductor substrate pattern collapse is also suitably usable as a resist underlayer film on a semiconductor substrate having an uneven pattern formed on a surface thereof. Since the heated filling film is excellent in solvent resistance, it can be used in various patterning processes, such as multilayer resist processes in which a silicon-containing middle layer film (silicon-containing resist middle layer film, inorganic hard mask middle layer film) is formed on the filling film without removing the filling film, and a normal organic photoresist film is formed as a resist upper layer film on the middle layer film; after a circuit pattern formed in the photoresist composition is transferred and formed by etching in a semiconductor substrate pattern having an uneven pattern formed therein and coated with the filling film, the filling film can be removed by dry etching. The continuous use of such highly clean material for forming a filling film for inhibiting semiconductor substrate pattern collapse as a resist underlayer film in multilayer resist processes without removal allows omission of steps of: removing the filling film for inhibiting semiconductor substrate pattern collapse which is applied after a semiconductor substrate is washed; and applying a resist underlayer film for multilayer resist process. Alternatively, it is possible to omit a drying step using no material for forming a filling film for inhibiting semiconductor substrate pattern collapse, such as drying using 2-propanol, by replacing this drying step with a step using the inventive material for forming a filling film for inhibiting semiconductor substrate pattern collapse. This can contribute to the process rationalization. Note that the usage is not limited to drying a semiconductor substrate, and the inventive material can also be utilized as a resist underlayer film for multilayer resist processes which is used to fill a semiconductor substrate pattern after the semiconductor substrate is dried in semiconductor-device manufacturing processes.

Examples of the multilayer resist processes include: silicon-involving 2-layer resist process; 3-layer resist process using a silicon-containing middle layer film; 4-layer resist process using a silicon-containing middle layer film and an organic thin film; silicon-free 2-layer resist process; etc. From the viewpoints of anti-reflection performance and cost, 3-layer resist process using a silicon-containing middle layer film is preferable.

As the silicon-containing resist middle layer film in multilayer resist processes, a polysilsesquioxane-based middle layer film is also preferably used. Reflection can be suppressed by imparting antireflective effect to a silicon-containing resist middle layer film. As the silicon-containing resist middle layer film having the antireflective effect, a polysilsesquioxane is preferably used, the polysilsesquioxane having anthracene for 248-nm and 157-nm light exposure, or a phenyl group or a light-absorbing group having a silicon-silicon bond for 193-nm light exposure in a pendant structure, and being crosslinked by an acid or heat.

In this case, forming a silicon-containing resist middle layer film by a spin-coating method is simpler and more advantageous regarding cost than a CVD method.

In the case where an inorganic hard mask middle layer film is formed on the filling film, a silicon oxide film, a silicon nitride film, and a silicon oxynitride film (SiON film) can be formed by a CVD method, an ALD method, or the like. For example, the method for forming the silicon nitride film is disclosed in JP 2002-334869 A and WO 2004/066377 A1. The film thickness of the inorganic hard mask middle layer film is preferably 5 to 200 nm, more preferably 10 to 100 nm. As the inorganic hard mask middle layer film, a SiON film is most preferably used which is effective as an antireflective coating. When a SiON film is formed, the semiconductor substrate temperature reaches 300 to 500°C. Hence, the filling film needs to withstand the temperature of 300 to 500°C.

The resist upper layer film in the multilayer resist processes may be a positive type or a negative type, and any generally-used photoresist composition can be employed. After spin-coating of the photoresist composition, pre-baking is preferably performed at 60 to 180°C for 10 to 300 seconds. Then, light exposure, post-exposure bake (PEB), and development are performed according to conventional methods to obtain the resist upper layer film pattern. Note that the thickness of the resist upper layer film is not particularly limited, but is preferably 30 to 500 nm, and 50 to 400 nm is particularly preferable.

When a circuit pattern (resist upper layer film pattern) is formed in the resist upper layer film in the multilayer resist processes, the circuit pattern is preferably formed by lithography using light with a wavelength of 10 nm or more and 300 nm or less, a direct drawing with electron beam, nanoimprinting, or a combination thereof.

Note that the exposure light includes high energy beam with a wavelength of 300 nm or less; specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) with a wavelength of 3 to 20 nm, electron beam (EB), ion beam, X-ray, etc.

Moreover, when the circuit pattern is formed, the circuit pattern is preferably developed by alkaline development or with an organic solvent.

Examples of the washing liquid used to wash the semiconductor substrate having an uneven pattern formed thereon include a sulfate ion-containing stripping solution, a chlorine ion-containing washing liquid, a fluorine ion-containing washing liquid, a nitrogen compound-containing alkaline washing liquid, a phosphoric acid-containing washing liquid, etc. The washing liquid preferably contains hydrogen peroxide. The washing step may be performed sequentially using two or more kinds of washing liquids. The sulfate ion-containing washing liquid is preferably a sulfuric acid-hydrogen peroxide mixture (SPM) containing hydrogen peroxide and sulfuric acid, which is suitable for removal of organic matter, such as resist. The chlorine ion-containing washing liquid is preferably a mixture aqueous solution of hydrogen peroxide and hydrochloric acid (SC-2), which is suitable for metal removal. Examples of the fluorine ion-containing washing liquid include a mixture aqueous solution of hydrofluoric acid and ammonium fluoride. The nitrogen compound-containing alkaline washing liquid is preferably a mixture aqueous solution of hydrogen peroxide and ammonia (SC-1), which is suitable for particle removal.

Examples of the rinsing liquid used to rinse the semiconductor substrate having an uneven pattern formed thereon include ultrapure water, a water-soluble alcohol, etc. The water-soluble alcohol is preferably 2-propanol. The rinsing step may be performed sequentially using two or more kinds of rinsing liquids. Preferably, after rinsing with ultrapure water, alcohol-rinsing treatment is performed for replacement with 2-propanol, followed by application of the material for forming a filling film for inhibiting semiconductor substrate pattern collapse.

The washing liquid or rinsing liquid is preferably a liquid containing any one or more of water, a water-soluble alcohol, and a fluorine compound.

The method of coating a semiconductor substrate with the material for forming a filling film for inhibiting semiconductor substrate pattern collapse is not particularly limited. The coating can be performed by an appropriate method, such as spin coating, cast coating, and roll coating, for example.

The method of drying the coating film obtained by applying the material for forming a filling film for inhibiting semiconductor substrate pattern collapse is not particularly limited. Typically, the drying is performed by heating under air atmosphere. The lower limit of the heating temperature is not particularly limited, but is preferably 40°C, more preferably 60°C, further preferably 100°C. The upper limit of the heating temperature is preferably 400°C, more preferably 350°C, further preferably 300°C. The lower limit of the heating time is preferably 15 seconds, more preferably 30 seconds, further preferably 45 seconds. The upper limit of the heating time is preferably 1,200 seconds, more preferably 600 seconds, further preferably 300 seconds.

Applying and drying the material for forming a filling film for inhibiting semiconductor substrate pattern collapse on an uneven pattern-formed semiconductor substrate as described above make it possible to fill recess portions of the pattern with the material for forming a filling film for inhibiting semiconductor substrate pattern collapse, and to inhibit such pattern collapse that a pattern comes into contact with an adjacent pattern. Since the material for forming a filling film for inhibiting semiconductor substrate pattern collapse uses the polymer (A), a high-molecular-weight compound can be produced by crosslinking reaction with the residual-solvent removal promoter (B) through heating. As a result, heat resistance is successfully imparted to the filling film. Even if part or all of such a filling film is heated during the removal from the top of the semiconductor substrate by dry etching or the like, the thermal melting is suppressed and the strength is easily maintained. Thus, it is possible to surely remove the filling film by dry etching or the like while suppressing semiconductor-substrate pattern collapse.

The atmosphere during the baking may be in air, or an inert gas such as N₂, Ar, and He may be introduced. In this event, the atmosphere may have an oxygen concentration of less than 0.1%. Additionally, the baking temperature, etc. can be the same as described above. Even when the uneven pattern-formed semiconductor substrate contains a material that is unstable under heating condition in an oxygen atmosphere, the crosslinking reaction of the material for forming a filling film for inhibiting semiconductor substrate pattern collapse can be promoted without degrading the semiconductor substrate.

The uneven pattern-formed semiconductor substrate is not particularly limited, as long as a pattern other than resist pattern is formed on the semiconductor substrate. Preferably, the semiconductor substrate has a semiconductor substrate pattern formed on at least one surface and contains silicon atom or metal atom. More preferably, the semiconductor substrate has metal, metal nitride, metal oxide, silicon oxide, silicon nitride film, silicon, or mixture thereof as the main component. Here, "main component" and related terms refer to a component with the largest content, for example, a component whose content is 50 mass% or more. Examples of the metal atom include titanium, tungsten, hafnium, zirconium, chromium, germanium, copper, silver, gold, aluminum, indium, gallium, arsenic, palladium, iron, tantalum, iridium, cobalt, manganese, molybdenum, etc.

Examples of the material constituting the semiconductor substrate pattern include those exemplified as the material of the semiconductor substrate, etc.

The semiconductor substrate pattern profile is not particularly limited. Examples thereof include fine structures, such as line-and-space pattern, island pattern, hole pattern, pillar pattern, and slit pattern. The upper limit of the average interval in the line-and-space pattern and island pattern is preferably 300 nm, more preferably 100 nm, further preferably 50 nm, particularly preferably 30 nm. The upper limit of the average interval in the hole pattern and pillar pattern is preferably 300 nm, more preferably 150 nm, further preferably 100 nm. The upper limit of the average interval in the slit pattern is preferably 2,000 nm, more preferably 1,500 nm. When the method for treating a semiconductor substrate is employed for a semiconductor substrate having a pattern with such a minute interval formed thereon, excellent performance of inhibiting semiconductor substrate pattern collapse can be exhibited to the maximum.

The lower limit of the average height in the line-and-space pattern and island pattern is preferably 100 nm, more preferably 200 nm, further preferably 300 nm, particularly preferably 400 nm. The upper limit of the average width of the line-and-space and island in the semiconductor substrate (for example, based on the central portion in the height direction) is preferably 50 nm, more preferably 40 nm, further preferably 30 nm, particularly preferably 20 nm. The lower limit of the aspect ratio (average height of the pattern/average width of the pattern) in the semiconductor substrate is preferably 5, more preferably 10, further preferably 15, particularly preferably 20.

The lower limit of the average height in the hole pattern is preferably 3,000 nm, more preferably 5,000 nm, further preferably 7,000 nm, particularly preferably 10,000 nm. The upper limit of the average width of the holes (for example, based on the central portion in the height direction) in the semiconductor substrate is preferably 300 nm, more preferably 150 nm, further preferably 100 nm. The lower limit of the aspect ratio (average height of the pattern/average width of the pattern) in the semiconductor substrate is preferably 10, more preferably 30, further preferably 50, particularly preferably 100.

The lower limit of the average height in the pillar pattern is preferably 100 nm, more preferably 200 nm, further preferably 300 nm, particularly preferably 400 nm. The upper limit of the average width of the pillars (for example, based on the central portion in the height direction) in the semiconductor substrate is preferably 50 nm, more preferably 40 nm, further preferably 30 nm, particularly preferably 20 nm. The lower limit of the aspect ratio (average height of the pattern/average width of the pattern) in the semiconductor substrate is preferably 5, more preferably 10, further preferably 15, particularly preferably 20.

The lower limit of the average height in the slit pattern is preferably 3,000 nm, more preferably 5,000 nm, further preferably 7,000 nm, particularly preferably 10,000 nm. The upper limit of the average width of the slits (for example, based on the central portion in the height direction) in the semiconductor substrate is preferably 500 nm, more preferably 300 nm, further preferably 150 nm. The lower limit of the aspect ratio (average height of the pattern/average width of the pattern) in the semiconductor substrate is preferably 3, more preferably 5, further preferably 10, particularly preferably 15.

The material for forming a filling film for inhibiting semiconductor substrate pattern collapse is widely applicable regardless of the type of the fine structure.

Moreover, in the present invention, a preferable method for treating a semiconductor substrate includes steps of:
forming a filling film by using the above-described material for forming a filling film for inhibiting semiconductor substrate pattern collapse to fill a semiconductor substrate having an uneven pattern formed on a surface thereof, the substrate having an aspect ratio of 5 or more; and
removing the filling film.

Note that the coating film formed by applying the formation material for inhibiting semiconductor substrate pattern collapse preferably fills recesses of a pattern. That is, the material for forming a filling film for inhibiting semiconductor substrate pattern collapse is suitably employable as a filling film. In addition, the thickness of the coating film is not particularly limited, but the lower limit of the average thickness of the coating film on the bulged surface of a semiconductor substrate pattern is preferably 0.01 µm, more preferably 0.02 µm, further preferably 0.05 µm. The upper limit of the average thickness is preferably 5 µm, more preferably 3 µm, further preferably 2 µm, particularly preferably 0.5 µm.

The coating film on the semiconductor substrate formed from the material for forming a filling film for inhibiting semiconductor substrate pattern collapse can be removed in gas phase. For this removal, for example, heat treatment, plasma treatment, dry etching (ashing), ultraviolet irradiation, electron beam irradiation, and the like can be employed. Removal by dry etching (ashing) is preferable.

The dry etching can be performed using a known dry etching apparatus. The etching gas used in the dry etching can be appropriately selected according to the elemental composition of the filling film for inhibiting substrate pattern collapse to be etched, etc. It is possible to use, for example, fluorine-based gases, such as CHF₃, CF₄, C₂F₆, C₃F₈, and SF₆; chlorine-based gases, such as Cl₂ and BCl₃; oxygen -based gas, such as O₂, O₃, and H₂O; reducing gases, such as H₂, NH₃, CO, CO₂, CH₄, C₂H₂, C₂H₄, C₂H₆, C₃H₄, C₃H₆, C₃H₈, HF, HI, HBr, HCl, NO, and BCl₃; inert gases, such as He, N₂, and Ar; etc. Note that these gases can also be used as a mixture.

### EXAMPLE

Hereinafter, the present invention will be more specifically described with reference to Synthesis Example, Examples, and Comparative Examples. However, the present invention is not limited thereto. Note that, regarding molecular weight and dispersity, weight-average molecular weight (Mw) and number-average molecular weight (Mn) were determined in terms of polystyrene by gel permeation chromatography (GPC) using tetrahydrofuran as an eluent, and the dispersity (Mw/Mn) was calculated therefrom.

### [Synthesis of Compounds]

### Synthesis of Polymer (A-1)

Under nitrogen atmosphere, 216.3 g of meta-cresol, 130.0 g of a 37% formaldehyde solution, 10.8 g of oxalic acid, and 200 g of dioxane were added together, and the reaction was allowed to proceed with an inner temperature of 100°C for 24 hours. After completion of the reaction, the resultant was cooled to room temperature, mixed with 2,000 ml of MIBK (methyl isobutyl ketone), and washed six times with 500 ml of pure water. The organic layer was collected and dried under reduced pressure. Thus, Polymer (A-1) was obtained. The weight-average molecular weight (Mw) and dispersity (Mw/Mn) were determined by GPC: Mw=7,000 and Mw/Mn=7.5.

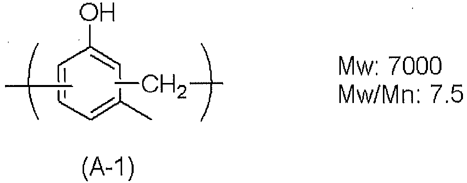

### Synthesis of Polymer (A-2)

Under nitrogen atmosphere, 160.2 g of 1,5-dihydroxynaphthalene, 64.9 g of a 37% formaldehyde solution, and 300 g of PGME (propylene glycol monomethyl ether) were added together and homogenized with an inner temperature of 100°C. Then, a homogenized mixture solution prepared in advance by mixing 8.0 g of p-toluenesulfonic acid monohydrate and 8.0 g of PGME was slowly added dropwise thereto, and the reaction was allowed to proceed with the inner temperature of 80°C for 8 hours. After completion of the reaction, the resultant was cooled to room temperature, mixed with 2,000 ml of MIBK, and washed six times with 500 ml of pure water. The organic layer was dried under reduced pressure. To the residue, 300 g of THF was added and a homogeneous solution was prepared. Subsequently, a crystal was precipitated in 2,000 g of hexane. The precipitated crystal was separated by filtration, washed twice with 500 g of hexane, and collected. The collected crystal was vacuum dried at 70°C. Thus, Polymer (A-2) was obtained. The weight-average molecular weight (Mw) and dispersity (Mw/Mn) were determined by GPC: Mw=4,000 and Mw/Mn=3.0.

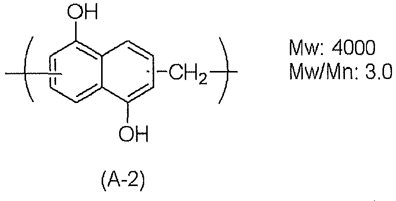

### Synthesis of Polymer (A-3)

Under nitrogen atmosphere, 100.0 g of Polymer (A-1), 172.3 g of potassium carbonate, and 500 g of DMF were added together to prepare a homogeneous dispersion with an inner temperature of 50°C. Then, 119.0 g of propargyl bromide was slowly added thereto, and the reaction was allowed to proceed with the inner temperature of 50°C for 24 hours. To the reaction solution, 1,000 ml of methyl isobutyl ketone and 1,000 g of pure water were added to dissolve the deposited salt. Subsequently, the separated aqueous layer was removed. Further, the organic layer was washed six times with 300 g of a 3% nitric acid aqueous solution and 300 g of pure water. Thereafter, the organic layer was dried under reduced pressure. To the residue, 300 g of THF was added and a homogeneous solution was prepared. Then, a crystal was precipitated in 2,000 g of hexane. The precipitated crystal was separated by filtration, washed twice with 500 g of hexane, and collected. The collected crystal was vacuum dried at 70°C. Thus, Polymer (A-3) was obtained. The weight-average molecular weight (Mw) and dispersity (Mw/Mn) were determined by GPC: Mw=10,000 and Mw/Mn=3.1.

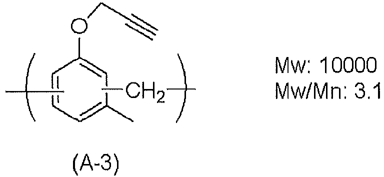

### Synthesis of Polymer (A-4)

Under nitrogen atmosphere, 188.2 g of phenol, 48.7 g of a 37% formaldehyde solution, 9.4 g of oxalic acid, and 200 g of dioxane were added together, and the reaction was allowed to proceed with an inner temperature of 100°C for 24 hours. After completion of the reaction, the resultant was cooled to room temperature, mixed with 2,000 ml of MIBK, and washed six times with 500 ml of pure water. The organic layer was collected, the pressure was reduced to 2 mmHg with an inner temperature of 150°C, and the water, solvent, and remaining monomer were removed under reduced pressure. Thus, Polymer (A-4) was obtained. The weight-average molecular weight (Mw) and dispersity (Mw/Mn) were determined by GPC: Mw=1,500 and Mw/Mn=1.5.

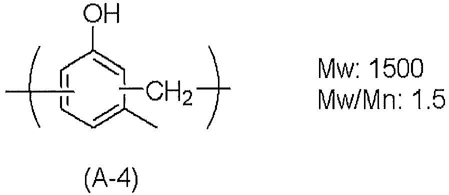

### Synthesis of Polymer (A-5)

Under nitrogen atmosphere, 188.2 g of phenol, 113.6 g of a 37% formaldehyde solution, 9.4 g of oxalic acid, and 200 g of dioxane were added together, and the reaction was allowed to proceed with an inner temperature of 100°C for 24 hours. After completion of the reaction, the resultant was cooled to room temperature, mixed with 2,000 ml of MIBK, and washed six times with 500 ml of pure water. The organic layer was collected and concentrated until the yield reached approximately 25 wt%. Then, while the resultant was being stirred, 1,000 g of a mixture solution containing methanol and pure water in 1:1 (weight ratio) was added thereto, and a polymer was precipitated. After the mixture was left standing for 1 hour, the supernatant was decanted. The precipitate was collected and dried under reduced pressure. Thus, Polymer (A-5) was obtained. The weight-average molecular weight (Mw) and dispersity (Mw/Mn) were determined by GPC: Mw=10,000 and Mw/Mn=1.5.

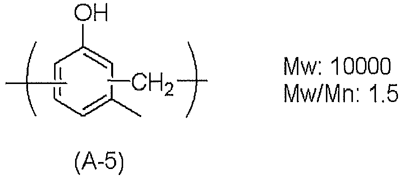

### Synthesis of Polymer (A-6)

Under nitrogen atmosphere, 60.0 g of 2-vinylnaphthalene, 40.0 g of vinyl benzyl alcohol, 300 g of methyl ethyl ketone, and 5.0 g of dimethyl 2,2-azobisisobutyrate were added together, and the reaction was allowed to proceed with an inner temperature of 80°C for 8 hours. After completion of the reaction, the resultant was cooled to room temperature. Subsequently, a crystal was precipitated in 3,000 g of heptane. The precipitated crystal was separated by filtration, washed twice with 500 g of heptane, and collected. The collected crystal was vacuum dried at 70°C. Thus, Polymer (A-6) was obtained. The weight-average molecular weight (Mw) and dispersity (Mw/Mn) were determined by GPC: Mw=4,500 and Mw/Mn=2.0.

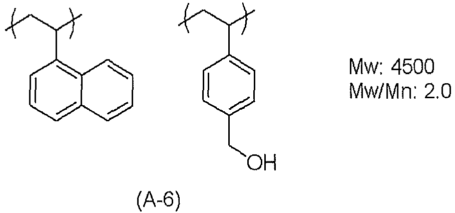

### [Preparation of Materials for Forming Filling Film for Inhibiting Semiconductor Substrate Pattern Collapse]

Materials for forming a filling film for inhibiting semiconductor substrate pattern collapse were prepared by using components shown below.

### [(A) Polymer]

The following were (A) Polymers (A-1) to (A-6) used in the materials for forming a filling film for inhibiting semiconductor substrate pattern collapse.

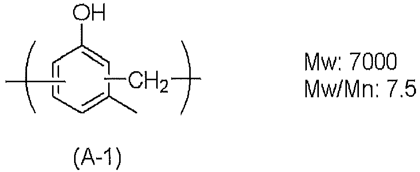

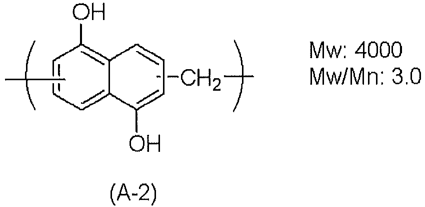

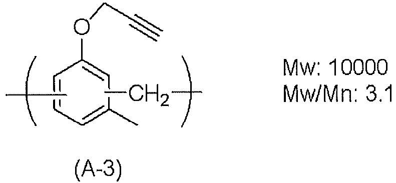

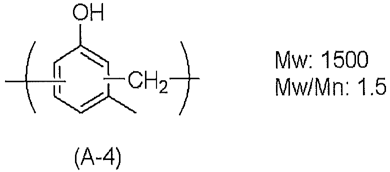

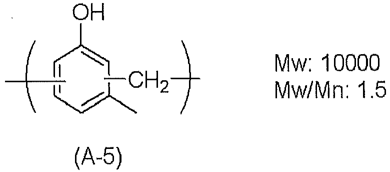

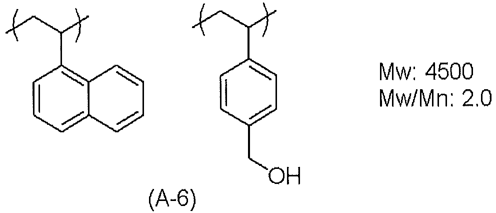

### [(B) Residual-Solvent Removal Promoter]

The following were (B) residual-solvent removal promoters used in the materials for forming a filling film for inhibiting semiconductor substrate pattern collapse.

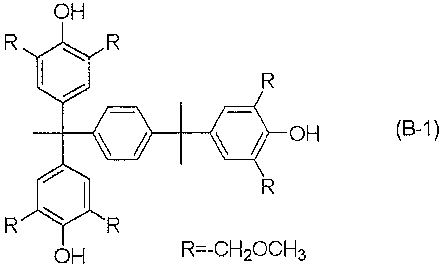

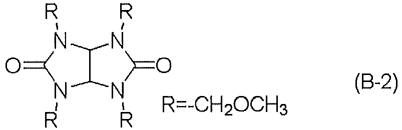

### [Composition FM-1]

100 parts by mass of (A-1) as the polymer (A), 15 parts by mass of (B-1) as the residual-solvent removal promoter (B), and 0.25 parts by mass of (D-1) FC-4430 (manufactured by 3M Corporation) as the surfactant (D) were dissolved in 1,150 parts by mass of (C-1) propylene glycol monomethyl ether acetate (PGMEA) as the organic solvent (C). The obtained solution was filtered through a membrane filter having a pore size of 0.02 µm. Thus, a material (FM-1) for forming a filling film for inhibiting semiconductor substrate pattern collapse was prepared.

### [Compositions FM-2 to -4 and Comparative FM-1 to -11]

Materials for forming a filling film for inhibiting semiconductor substrate pattern collapse were prepared by the same operation as for FM-1, except that the kinds and contents of the components were as shown in Tables 1 to 3. Note that, in Tables 1 to 3, "-" indicates that the corresponding component was not used. (E-1) in the following formula was used as an acid generator (TAG), and 1,6-diacetoxyhexane with a boiling point of 260°C was used as a high-boiling-point solvent (C-2).

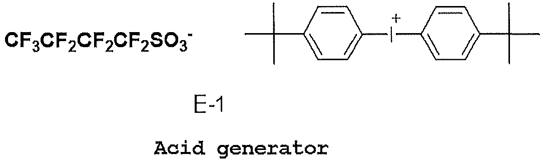

**[Table 1]**

| Composition | Filling film thickne ss (nm) | (A) Polymer | | (B) Residual -solvent removal promoter | | High-boiling-point solvent | | (D) Surfactant | | (E) Acid genera-tor | | (C) Solvent | |
|---|---|---|---|---|---|---|---|---|---|---|---|---|---|
| | | (parts by mass) | | (parts by mass) | | (parts by mass) | | (parts by mass) | | (parts by mass) | | (parts by mass) | |
| EM-1 | 200 | A-1 | 100 | B-1 | 15 | - | - | D-1 | 0.25 | - | - | C-1 | 1150 |
| | 3000 | A-1 | 100 | B-1 | 15 | - | - | D-1 | 0.25 | - | - | C-1 | 230 |
| | 5000 | A-1 | 100 | B-1 | 15 | - | - | D-1 | 0.25 | - | - | C-1 | 170 |
| FM-2 | 200 | A-2 | 100 | B-1 | 15 | - | - | D-1 | 0.25 | - | - | C-1 | 1150 |
| | 3000 | A-2 | 100 | B-1 | 15 | - | - | D-1 | 0.25 | - | - | C-1 | 230 |
| | 5000 | A-2 | 100 | B-1 | 15 | - | - | D-1 | 0.25 | - | - | C-1 | 170 |
| EM-3 | 200 | A-1/ A-3 | 30/ 70 | B-1 | 15 | - | - | D-1 | 0.25 | - | - | C-1 | 1150 |
| | 3000 | A-1/ A-3 | 30/ 70 | B-1 | 15 | - | - | D-1 | 0.25 | - | - | C-1 | 230 |
| | 5000 | A-1/ A-3 | 30/ 70 | B-1 | 15 | - | - | D-1 | 0.25 | - | - | C-1 | 170 |
| EM-4 | 200 | A-1 | 100 | B-1 | 15 | C-2 | 50 | D-1 | 0.25 | - | - | C-1 | 1550 |
| | 3000 | A-1 | 100 | B-1 | 15 | C-2 | 50 | D-1 | 0.25 | - | - | C-1 | 310 |
| | 5000 | A-1 | 100 | B-1 | 15 | C-2 | 50 | D-1 | 0.25 | - | - | C-1 | 240 |

**[Table 2]**

| Camposition | Filling film thickness (nm) | (A) Polymer | | (B) Residual -solvent removal promoter | | High-boiling -point solvent | | (D) Surfactant | | (E) Acid genera-tor | | (C) Solvent | |
|---|---|---|---|---|---|---|---|---|---|---|---|---|---|
| | | (parts by mass) | | (parts by mass) | | (parts by mass) | | (parts by mass) | | (parts by mass) | | (parts by mass) | |
| Comparative FM-1 | - | - | - | - | - | - | - | - | - | - | - | water | 100 |
| Comparative EM-2 | - | - | - | - | - | - | - | - | - | - | - | 2-propa nol | 100 |
| Comparative FM-3 | 200 | A-1 | 100 | - | - | - | - | D-1 | 0.25 | - | - | C-1 | 1150 |
| | 3000 | A-1 | 100 | - | - | - | - | D-1 | 0.25 | - | - | C-1 | 230 |
| | 5000 | A-1 | 100 | - | - | - | - | D-1 | 0.25 | - | - | C-1 | 170 |
| Comparative FM-4 | 200 | A-1 | 100 | B-1 | 15 | - | - | D-1 | 0.25 | E-1 | 4.8 | C-1 | 1150 |
| | 3000 | A-1 | 100 | B-1 | 15 | - | - | D-1 | 0.25 | E-1 | 4.8 | C-1 | 230 |
| | 5000 | A-1 | 100 | B-1 | 15 | - | - | D-1 | 0.25 | E-1 | 4.8 | C-1 | 170 |
| Comparative FM-5 | 200 | A-4 | 100 | - | - | - | - | D-1 | 0.25 | - | - | C-1 | 1150 |
| | 3000 | A-4 | 100 | - | - | - | - | D-1 | 0.25 | - | - | C-1 | 230 |
| | 5000 | A-4 | 100 | - | - | - | - | D-1 | 0.25 | - | - | C-1 | 170 |
| Comparative FM-6 | 200 | A-5 | 100 | - | - | - | - | D-1 | 0.25 | - | - | C-1 | 1150 |
| | 3000 | A-5 | 100 | - | - | - | - | D-1 | 0.25 | - | - | C-1 | 230 |
| | 5000 | A-5 | 100 | - | - | - | - | D-1 | 0.25 | - | - | C-1 | 170 |
| Carparative EM-7 | 200 | A-5 | 100 | B-1 | 15 | - | - | D-1 | 0.25 | - | - | C-1 | 1150 |
| | 3000 | A-5 | 100 | B-1 | 15 | - | - | D-1 | 0.25 | - | - | C-1 | 230 |
| | 5000 | A-5 | 100 | B-1 | 15 | - | - | D-1 | 0.25 | - | - | C-1 | 170 |
| Comparative FM-8 | 200 | A-1 | 100 | B-1 | 50 | - | - | D-1 | 0.25 | - | - | C-1 | 2400 |
| | 3000 | A-1 | 100 | B-1 | 50 | - | - | D-1 | 0.25 | - | - | C-1 | 490 |
| | 5000 | A-1 | 100 | B-1 | 50 | - | - | D-1 | 0.25 | - | - | C-1 | 365 |

**[Table 3]**

| Composition | Filling film thickness (nm) | (A) Polymer | | (B) Residual-solvent removal promoter | | High-boiling-point solvent | | (D) Surfactant | | (E) Acid genera-tor | | (C) Solvent | |
|---|---|---|---|---|---|---|---|---|---|---|---|---|---|
| | | (parts by mass) | | (parts by mass) | | (parts by mass) | | (parts by mass) | | (parts by mass) | | (parts by mass) | |
| Comparative FM-9 | 200 | A-1 | 100 | B-2 | 15 | - | - | D-1 | 0.25 | - | - | C-1 | 1505 |
| | 3000 | A-1 | 100 | B-2 | 15 | - | - | D-1 | 0.25 | - | - | C-1 | 320 |
| | 5000 | A-1 | 100 | B-2 | 15 | - | - | D-1 | 0.25 | - | - | C-1 | 230 |
| Comparative EM-10 | 200 | A-3 | 100 | B-1 | 15 | - | - | D-1 | 0.25 | - | - | C-1 | 1150 |
| | 3000 | A-3 | 100 | B-1 | 15 | - | - | D-1 | 0.25 | - | - | C-1 | 230 |
| | 5000 | A-3 | 100 | B-1 | 15 | - | - | D-1 | 0.25 | - | - | C-1 | 170 |
| Comparative FM-11 | 200 | A-6 | 100 | B-1 | 15 | - | - | D-1 | 0.25 | - | - | C-1 | 1000 |
| | 3000 | A-6 | 100 | B-1 | 15 | - | - | D-1 | 0.25 | - | - | C-1 | 200 |
| | 5000 | A-6 | 100 | B-1 | 15 | - | - | D-1 | 0.25 | - | - | C-1 | 150 |

### <Filling Film Formation>

Each of the materials for forming a filling film for inhibiting semiconductor substrate pattern collapse which were prepared as FM-1 to -4 and Comparative FM-3 to -11 was applied to a surface of a semiconductor substrate where an uneven pattern had been formed. The resultant was baked in the atmosphere at 250°C for 60 seconds to form a filling film. As the semiconductor substrate, three kinds of silicon wafers (Semiconductor substrates A to C) were used on which different uneven patterns had been formed.

Semiconductor substrate A: a silicon wafer having a line-and-space pattern with heights of 6,000 nm, an average line width of 150 nm, an average line pitch of 400 nm, and an aspect ratio of 40.

Semiconductor substrate B: a silicon wafer having a hole pattern with heights of 8,000 nm, an average hole width of 380 nm, an average hole pitch of 500 nm, and an aspect ratio of 20.

Semiconductor substrate C: a silicon wafer having a line-and-space pattern with heights of 400 nm, an average line width of 30 nm, an average line pitch of 45 nm, and an aspect ratio of 13.

The materials FM-1 to -4 and Comparative FM-1 to - 11 for forming a filling film for inhibiting semiconductor substrate pattern collapse were evaluated regarding film thickness uniformity, filling property, and pattern-collapse inhibition performance by the following methods. Moreover, the metal impurity amount on the semiconductor substrate surface after the filling film removal was evaluated in Example 4-1 and Comparative Example 4-1 by the following method.

### [Film Thickness Uniformity]

The silicon wafer substrates with the filling films (FM-1 to -4 and Comparative FM-3 to -11) formed thereon were sliced to evaluate the film thickness uniformity of each filling film in the cross section by using FE-SEM ("S4800" manufactured by Hitachi High-Technologies Corporation). In Comparative Examples 1-1 to 1-2, since no filling film were formed, the coating property was not evaluated. The evaluation sites were as follows.

Semiconductor substrate A: among film thicknesses in the uneven pattern dense portion on the pattern, film thickness 1 at the center portion of the silicon wafer substrate and film thickness 2 at a peripheral portion thereof were measured. If the film thickness difference between the film thickness 1 and the film thickness 2 was 60 nm or less, the material was evaluated as "A" (quite favorable). If the difference was 61 to 90 nm, the material was evaluated as "B" (favorable). If the difference was 91 nm or more, the material was evaluated as "C" (poor).

Semiconductor substrate B: film thickness 1 at the center portion of the silicon wafer substrate and film thickness 2 at a peripheral portion thereof were measured. If the film thickness difference between the film thickness 1 and the film thickness 2 was 100 nm or less, the material was evaluated as "A" (quite favorable). If the difference was 101 to 150 nm, the material was evaluated as "B" (favorable). If the difference was 151 nm or more, the material was evaluated as "C" (poor).

Semiconductor substrate C: film thickness 1 at the center portion of the silicon wafer substrate and film thickness 2 at a peripheral portion thereof were measured. If the film thickness difference between the film thickness 1 and the film thickness 2 was 4 nm or less, the material was evaluated as "A" (quite favorable). If the difference was 5 to 6 nm, the material was evaluated as "B" (favorable). If the difference was 7 nm or more, the material was evaluated as "C" (poor).

**[Table 4]**

| | Composition | Semiconductor substrate A | | Semiconductor substrate B | | Semiconductor substrate C | |
|---|---|---|---|---|---|---|---|
| | | film thickness | result | film thickness | result | film thickness | result |
| Example 1-1 | EM-1 | 3000 nm | A | 5000 nm | A | 200 nm | A |
| Example 2-1 | EM-2 | 3000 nm | A | 5000 nm | A | 200 nm | A |
| Example 3-1 | EM-3 | 3000 nm | A | 5000 nm | A | 200 nm | A |
| Example 4-1 | EM-4 | 3000 nm | A | 5000 nm | A | 200 nm | A |
| Comparative Example 1-1 | Comparative EM-1 | - | - | - | - | - | - |
| Comparative Example 2-1 | Comparative FM-2 | - | - | - | - | - | - |
| Comparative Example 3-1 | Comparative FM-3 | 3000 nm | B | 5000 nm | B | 200 nm | B |
| Comparative Example 4-1 | Comparative FM-4 | 3000 nm | A | 5000 nm | A | 200 nm | A |
| Carparative Example 5-1 | Comparative EM-5 | 3000 nm | C | 5000 nm | C | 200 nm | B |
| Carparative Example 6-1 | Camparative FM-6 | 3000 nm | B | 5000 nm | B | 200 nm | B |
| Carparative Example 7-1 | Comparative FM-7 | 3000 nm | A | 5000 nm | A | 200 nm | A |
| Comparative Example 8-1 | Carparative EM-8 | 3000 nm | B | 5000 nm | B | 200 nm | B |
| Comparative Example 9-1 | Comparative FM-9 | 3000 nm | B | 5000 nm | B | 200 nm | B |
| Camparative Example 10-1 | Comparative EM-10 | 3000 nm | A | 5000 nm | A | 200 nm | A |
| Comparative Example 11-1 | Comparative EM-11 | 3000 nm | A | 5000 nm | A | 200 nm | A |

It can be seen as shown in Table 4 that Examples 1-1 to 4-1 using the inventive materials for forming a filling film for inhibiting semiconductor substrate pattern collapse (FM-1 to -4) ensured excellent film thickness uniformity even on the uneven pattern-formed substrates with high aspect ratios. In contrast, Comparative Examples 3-1, 5-1 and 6-1 not containing the residual-solvent removal promoter (B-1) did not ensure film thickness uniformity due to sublimation of the low-molecular-weight components in the polymer (A). This result suggests that adding the residual-solvent removal promoter (B-1) contributes to the improvement of the film thickness uniformity. Moreover, based on Comparative Example 5-1, when Polymer (A-4) with a low molecular weight and narrow molecular weight dispersity was used as the polymer (A), large amounts of sublimation products were generated, so that the film thickness uniformity was considerably degraded. Particularly, in the evaluations on the substrates A and B which require thick filling films, significant degradation of film thickness uniformity was observed. This result suggests that the polymer (A) preferably has a molecular weight of 3000 or more so as to achieve sufficient film thickness uniformity. Meanwhile, in Comparative Example 8-1 using Comparative FM-8, in which the content of the residual-solvent removal promoter (B-1) exceeds 50 parts by mass based on 100 parts by mass of the polymer (A), a sublimation product was generated from the residual-solvent removal promoter (B), and film thickness uniformity degradation was observed. From this result, there is an optimum amount of the residual-solvent removal promoter (B) to be added; in the present invention, 0.1 to 40 parts by mass, preferably 15 parts by mass, is necessary based on 100 parts by mass of the polymer (A). Moreover, in Comparative Example 9-1, in which Comparative FM-9 containing the additive (B-2) with no compound shown by the general formula (2) was used as the residual-solvent removal promoter (B), film thickness uniformity was not ensured presumably because the crosslinking reactivity with the polymer (A) was insufficient. This result indicates that the residual-solvent removal promoter (B) needs to contain the compound shown by the general formula (2).

### [Filling Property]

The silicon wafer substrates with the filling films (FM-1 to -4 and Comparative FM-3 to -11) formed thereon were sliced to evaluate the filling property of each filling film in the cross section by using an electron microscope (S-4700) manufactured by Hitachi, Ltd. Regarding the embedding or filling property, if the filling film was embedded to the pattern bottom portion without cracking the filling film or deforming the pattern profile, such as curving, and the pattern top portion was not exposed, the material was evaluated as "A" (quite favorable). If the filling film was embedded to the pattern bottom portion but void or crack was observed in the filling film, or if the filling film was embedded to the pattern bottom portion but deformation such as curving was observed in the pattern profile, the material was evaluated as "B" (favorable). If the filling film was not embedded to the pattern bottom portion and the top portion was exposed, the material was evaluated as "C" (poor). In Comparative Examples 1-2 to 2-2, since no filling film was formed, the filling property was not evaluated.

**[Table 5]**

| | Carposition | Semiconductor substrate A | | Semiconductor substrate B | | Semiconductor substrate C | |
|---|---|---|---|---|---|---|---|
| | | film thickness | result | film thickness | result | film thickness | result |
| Example 1-2 | EM-1 | 3000 nm | A | 5000 nm | A | 200 nm | A |
| Example 2-2 | EM-2 | 3000 nm | A | 5000 nm | A | 200 nm | A |
| Example 3-2 | EM-3 | 3000 nm | A | 5000 nm | A | 200 nm | A |
| Example 4-2 | EM-4 | 3000 nm | A | 5000 nm | A | 200 nm | A |
| Camparative Example 1-2 | Comparative EM-1 | - | - | - | - | - | - |
| Comparative Example 2-2 | Comparative FM-2 | - | - | - | - | - | - |
| Comparative Example 3-2 | Comparative FM-3 | 3000 nm | B | 5000 nm | B | 200 nm | B |
| Comparative Example 4-2 | Comparative EM-4 | 3000 nm | B | 5000 nm | B | 200 nm | B |
| Comparative Example 5-2 | Comparative FM-5 | 3000 nm | B | 5000 nm | B | 200 nm | B |
| Comparative Example 6-2 | Comparative EM-6 | 3000 nm | C | 5000 nm | C | 200 nm | C |
| Comparative Example 7-2 | Camparative FM-7 | 3000 nm | C | 5000 nm | C | 200 nm | C |
| Comparative Example 8-2 | Camparative FM-8 | 3000 nm | B | 5000 nm | B | 200 nm | B |
| Carparative Example 9-2 | Comparative FM-9 | 3000 nm | B | 5000 nm | B | 200 nm | B |
| Comparative Example 10-2 | Comparative EM-10 | 3000 nm | B | 5000 nm | B | 200 nm | B |
| Comparative Example 11-2 | Comparative FM-11 | 3000 nm | B | 5000 nm | B | 200 nm | B |

It can be seen as shown in Table 5 that in Examples 1-2 to 4-2 using the inventive materials for forming a filling film for inhibiting semiconductor substrate pattern collapse (FM-1 to -4), in which the polymer (A) and the residual-solvent removal promoter (B) were combined, excellent filling property was ensured on each uneven pattern-formed semiconductor substrate with high aspect ratio.

In contrast, in Comparative Examples 3-2 and 5-2 using Comparative FM-3 and Comparative FM-5 both not containing the residual-solvent removal promoter (B), voids were observed in the filling films. The larger the aspect ratio of the semiconductor substrate pattern, the more hardly the residual solvent was removed from the filling film filling the recesses. By heating, the residual solvent possessed by the polymer filling the recesses was removed, but the curing of the filling film also progresses simultaneously. This presumably caused the residual solvent entrapped in the cured film to foam and form voids.

In contrast, in the inventive materials for forming a filling film for inhibiting semiconductor substrate pattern collapse (FM-1 to -4), the residual-solvent removal promoter (B) is added, so that the residual solvent held by the polymer (A) is readily removed from the filling film, making it possible to form void-free filling film. The mechanism of facilitating the removal of the residual solvent possessed by the polymer (A) is presumably such that high-dimensional crosslinking between the polymer (A) and the compound of the residual-solvent removal promoter (B) lowers the affinity between the polymer (A) and the organic solvent (C), thereby facilitating the evaporation of the organic solvent.

Meanwhile, in Comparative Example 4-2 using Comparative FM-4 containing an acid generator, voids in the filling film and curving of the pattern profile were observed. This is presumably because when an acid generator is incorporated in the material for forming a filling film for inhibiting semiconductor substrate pattern collapse, the crosslinking reaction acceleratingly progresses between the polymer (A) and the residual-solvent removal promoter (B), so that the resulting filling film rapidly contracts, physical stress strongly acts on the semiconductor substrate pattern, and the pattern profile is curved. Further, it is also presumed that since the curing of the filling film is completed before the removal of the residual solvent is completed, the residual solvent entrapped in the cured film foams and voids are formed. For the same reasons as of Comparative Example 4-2, the defect observed in Comparative Example 8-2 using Comparative FM-8 containing the residual-solvent removal promoter (B) in an amount of 50 parts by mass was also presumably caused by the accelerated promotion of the crosslinking reaction by the excessively-added residual-solvent removal promoter (B). Thus, in the present invention, the composition does not contain an acid generator, and requires that the content of the residual-solvent removal promoter (B) be 0.1 to 40 parts by mass, preferably 15 parts by mass, based on 100 parts by mass of the polymer.

Further, as in Comparative FM-6 and Comparative FM-7, if the molecular weight dispersity (Mw/Mn) of the polymer is narrow, the flowability becomes poor. Consequently, in Comparative Examples 6-2 and 7-2, the filling films were not embedded to the pattern bottom portion, and the exposed pattern top portion was observed. Based on this result, the polymer (A) used in the material for forming a filling film for inhibiting semiconductor substrate pattern collapse preferably has wide molecular weight dispersity (Mw/Mn) in order to enhance the flowability, and the molecular weight dispersity (Mw/Mn) needs to satisfy the range of 2.50≤Mw/Mn≤9.00 in the present invention.

In Comparative Example 9-2 using Comparative FM-9 containing the additive (B-2) as the residual-solvent removal promoter (B) with no compound shown by the general formula (2), the removal of the residual solvent possessed by the polymer (A) was insufficient, and voids were observed in the filling film. Based on this result, the present invention needs to use the residual-solvent removal promoter (B) containing the compound shown by (2) .

In Comparative Example 10-2, crack was observed at the interface between the semiconductor substrate pattern and the filling film. This is presumably because the adhesiveness between the filling film and the semiconductor substrate pattern was lowered by heating due to high hydrophobicity of Polymer (A-3). In contrast, in Example 3-2, 30 parts by mass of Polymer (A-1) was mixed with 70 parts by mass of Polymer (A-3), so that the adhesiveness to semiconductor substrate pattern was improved, and excellent filling property was exhibited. Polymer (A-3) has low viscosity and excellent filling property, but the adhesiveness to the semiconductor substrate is degraded. Accordingly, Polymer (A-3) is preferably used as a mixture with Polymer (A-1). In the present invention, the mixing ratio of (A-1)/(A-3) = 30 parts by mass/70 parts by mass is preferable.

In Comparative Example 11-2 using Comparative FM-11 containing Polymer (A-6) with no structural unit shown by the general formula (1) of the present invention, since a large amount of residual solvent is possessed by the polymer, even when the residual-solvent removal promoter (B) was used, the removal of the residual solvent possessed by the polymer was insufficient, and voids were observed in the filling film. This result indicates that the present invention requires the polymer having a structural unit shown by the general formula (1).

### [Pattern-Collapse Inhibition Performance]

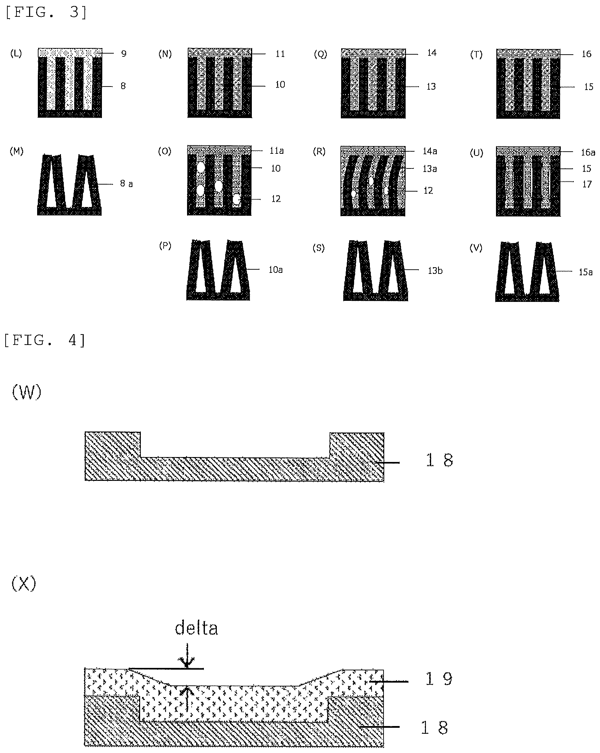

The filling film was removed by a dry etching (ashing) treatment using an etching apparatus Telius manufactured by Tokyo Electron Limited. The number of lines remaining without collapsing on semiconductor substrate C after the removal was counted on an observation image of the aforementioned electron microscope (S-4700). Regarding the performance of inhibiting substrate pattern collapse, if the proportion of lines remaining without collapsing exceeded 90%, the material was evaluated as "A" (quite favorable). If the proportion of lines remaining without collapsing was more than 70% but 90% or less, the material was evaluated as "B" (favorable). If the proportion of lines remaining without collapsing was 70% or less, the material was evaluated as "C" (poor). FIG. 3 specifically shows the defects in inhibiting substrate pattern collapse. In Comparative Examples 1-3 to 2-3, Comparative FM-1 to -2 was applied to a substrate. The resultant was baked in the atmosphere at 250°C for 60 seconds. After baked, pattern-collapse inhibition performance of the substrate was evaluated.

The dry etching (ashing) treatment conditions were as follows.

| | |
|---|---|
| Chamber pressure: | 2.5 Pa |
| RF power: | 1,000 W |
| N₂ gas flow rate: | 500 (mL/min) |
| H₂ gas flow rate: | 30 (mL/min) |

**[Table 6]**

| | Composition | Semiconductor substrate C | |
|---|---|---|---|
| | | film thickness | result |
| Example 1-3 | EM-1 | 200 nm | A |
| Example 2-3 | FM-2 | 200 nm | A |
| Example 3-3 | EM-3 | 200 nm | A |
| Example 4-3 | EM-4 | 200 nm | A |
| Comparative Example 1-3 | Camparative FM-1 | - | C |
| Comparative Example 2-3 | Comparative FM-2 | - | C |
| Comparative Example 3-3 | Comparative FM-3 | 200 nm | B |
| Comparative Example 4-3 | Comparative EM-4 | 200 nm | B |
| Comparative Example 5-3 | Comparative FM-5 | 200 nm | B |
| Comparative Example 6-3 | Comparative FM-6 | 200 nm | C |
| Comparative Example 7-3 | Comparative EM-7 | 200 nm | C |
| Comparative Example 8-3 | Carparative EM-8 | 200 nm | B |
| Comparative Example 9-3 | Camparative FM-9 | 200 nm | B |
| Comparative Example 10-3 | Comparative EM-10 | 200 nm | B |
| Camparative Example 11-3 | Comparative EM-11 | 200 nm | B |

It can be seen as shown in Table 6 that Examples 1-3 to 4-3 using the inventive materials for forming a filling film for inhibiting semiconductor substrate pattern collapse (FM-1 to -4) ensured excellent pattern-collapse inhibition performance even on the uneven pattern-formed semiconductor substrate with high aspect ratio. In contrast, in Comparative Examples 1-3 to 2-3, considerable pattern collapses were observed (semiconductor substrate 8 having a pattern with high aspect ratio, and washing liquid or rinsing liquid 9 (FIG. 3 (L)); semiconductor substrate pattern 8a with the pattern collapsing after drying (FIG. 3 (M))). From this result, water and 2-propanol in the conventional techniques were insufficient to inhibit pattern collapse with high aspect ratio, and the treatment method using the inventive materials for forming a filling film for inhibiting semiconductor substrate pattern collapse (FM-1 to -4) is preferable.

Meanwhile, pattern collapses were observed also in Comparative Examples 3-3 to 9-3, and 11-3, which treated Comparative Examples 3-2 to 9-2, and 11-2 found to have voids in the filling films in the above-described filling property evaluation (semiconductor substrate 10 having a pattern with high aspect ratio, and filling film 11 (FIG. 3 (N)); cured filling film 11a with voids, and voids 12 (FIG. 3 (O)); and semiconductor substrate pattern 10a with the pattern collapsing after removal of the filling film with voids (FIG. 3 (P))). From this result, the higher the aspect ratio of pattern, the greater the influence that is exerted on pattern collapse by voids in the filling film when the filling film is removed. This indicates that filling ability to surely fill recesses of a semiconductor substrate pattern is essential for the material for forming a filling film for inhibiting semiconductor substrate pattern collapse.

Additionally, considerable pattern collapses were observed also in Comparative Examples 4-3 and 8-3, which treated Comparative Examples 4-2 and 8-2 found to have the pattern profiles curved in the above-described filling property evaluation (semiconductor substrate 13 having a pattern with high aspect ratio, and filling film 14 (FIG. 3 (Q)); pattern profile 13a curved by thermal contraction of filling film, and cured filling film 14a with voids (FIG. 3 (R)); and semiconductor substrate pattern 13b with the pattern collapsing after removal of the filling film with voids (FIG. 3 (S))), and in Comparative Example 10-3, which treated Comparative Example 10-2 found to have crack at the interface between the semiconductor substrate pattern and the filling film (semiconductor substrate 15 having a pattern with high aspect ratio, and filling film 16 (FIG. 3 (T)); cured filling film 16a with crack, and crack 17 (FIG. 3 (U)); and semiconductor substrate pattern 15a with the pattern collapsing after removal of the filling film with crack (FIG. 3 (V))). It can be seen from these results that the semiconductor substrate pattern collapse after the filling-film removal were caused by defects including not only voids during filling but also curving of pattern profile, crack at the interface between the filling film and the substrate, etc. In the present invention, the materials for forming a filling film for inhibiting semiconductor substrate pattern collapse contain the polymer (A) and the residual-solvent removal promoter (B) but no acid generator. This composition presumably enables: suppression of defects, such as voids in the filling film, curved pattern profile, and crack at the interface of the filling film and the substrate; and formation of a filling film having high performance of inhibiting semiconductor-substrate pattern collapse after the filling-film removal.

### [Metal Impurity Amount on Semiconductor Substrate Surface after Filling-Film Removal]

Filling film materials for inhibiting semiconductor substrate pattern collapse of Example 1-4 and Comparative Example 1-4, which had different metal impurity amounts as shown in Table 7, were applied to silicon substrate surfaces and baked at 250°C for 60 seconds to form filling films each having a film thickness of 3,000 nm. Then, the filling film was removed by dry etching, and the metal impurity amount on the silicon substrate surface was evaluated by using a system with Expert VPD-ICP-MS manufactured by IAS Inc. The metal types evaluated were Na, Mg, K, Ca, Mn, Fe, Ni, Cu and Ti. If the metal impurity amount was 2.0×10E⁺¹⁰ (atoms/cm²) or less, the material was evaluated as "A" (favorable). If the metal impurity amount exceeded 2.0×10E⁺¹⁰ (atoms/cm²), the material was evaluated as "B" (poor).

**[Table 7]**

| Metal impurity amounts (ppb) in filling-film materials for inhibiting semiconductor substrate pattern collapse | | | | | | | | | |
|---|---|---|---|---|---|---|---|---|---|
| metal type | Na | Mg | K | Ca | Mn | Fe | Ni | Cu | Ti |
| Example 1-4 | <3 | <3 | <3 | <3 | <3 | <3 | <3 | <3 | <3 |
| Comparative Example 1-4 | 10< | 10< | 10< | 10< | 10< | 10< | 10< | 10< | 10< |

**[Table 8]**

| Metal impurity amounts (x10E⁺¹⁰ atoms/cm²) on semiconductor substrate surface after filling-film removal | | | | | | | | | | |
|---|---|---|---|---|---|---|---|---|---|---|
| metal type | Na | Mg | K | Ca | Mn | Fe | Ni | Cu | Ti | result |
| Example 1-4 | <1 | <1 | <1 | <1 | <1 | <1 | <1 | <1 | <1 | A |
| Comparative Example 1-4 | 11 | 10 | 6 | 6 | 5 | 5 | 4 | 4 | 5 | B |

The metal impurity amount in the inventive material for forming a filling film for inhibiting semiconductor substrate pattern collapse (Example 1-4) was not more than 3 ppb, and the maximum value of the metal impurity amount on the semiconductor substrate surface after the filling film removal was not more than 2.0x10E⁺¹⁰ (atoms/cm²) as shown in Table 8. These revealed that excellent cleanliness was ensured. In contrast, in Comparative Example 1-4, it was found that the metal impurity amount exceeded 10 ppb, and the metal impurity amount on the semiconductor substrate surface after the filling film removal exceeded 2.0×10E⁺¹⁰ (atoms/cm²). From this result, in the present invention, the metal impurity amount in the material for forming a filling film for inhibiting semiconductor substrate pattern collapse is preferably 3 ppb or less in order to reduce the metal impurity amount on the semiconductor substrate surface after the filling film removal. Controlling the impurity amount of each metal with the above range can prevent the device yield and reliability from lowering. Note that, in this evaluation, the evaluation was performed using the filling films having a film thickness of 3,000 nm so that the metal impurity amount in the material for forming a filling film for inhibiting semiconductor substrate pattern collapse would influence the performance. This is a strict evaluation condition to evaluate cleanliness after the filling film removal.

Each filling film formed by applying the inventive materials for forming a filling film for inhibiting semiconductor substrate pattern collapse is suitably employable as a resist underlayer film for a semiconductor substrate having an uneven pattern formed on the surface. After heated, the filling film is excellent in solvent resistance. Thus, the filling film can be used in various patterning processes including multilayer resist processes such that a silicon-containing middle layer film (silicon-containing resist middle layer film, inorganic hard mask middle layer film) is formed on the filling film without removing the filling film, and a normal organic photoresist film serving as a resist upper layer film is formed on the middle layer film. The photoresist composition is used to form a circuit pattern therein. This circuit pattern is transferred by etching and formed in an uneven pattern-formed semiconductor substrate pattern which has been coated with the filling film. After that, this filling film can be removed by dry etching. The materials for forming a filling film for inhibiting semiconductor substrate pattern collapse (FM-1 to -4, Comparative FM-3 to -11) shown in Tables 1 to 3 were evaluated with respect to solvent resistance, planarizing property, and pattern formation by the following methods.

### [Solvent Resistance]

Each of the materials for forming a filling film for inhibiting semiconductor substrate pattern collapse (FM-1 to -4, Comparative FM-3 to -11) was applied onto a silicon substrate and baked at 250°C for 60 seconds. Then, the film thickness (a [Å]) was measured. A PGMEA solvent was dispensed on the film. The resultant was left standing for 30 seconds, spin dried, and baked at 100°C for 60 seconds to evaporate the PGMEA, and the resulting film thickness (b [Å]) was measured. The film thickness difference before and after the PGMEA treatment (film remaining percentage: (b/a)×100) was determined. The result is shown below in Table 9. In Comparative Examples 1-5 to 2-5, since no filling film was formed, the solvent resistance was not evaluated.

**[Table 9]**

| | Composition | Film thickness after film formation: a | Film thickness after PGMEA treatment: b | b/a×100 (%) |
|---|---|---|---|---|
| | | (Å) | (Å) | (Å) |
| Example 1-5 | FM-1 | 30007.4 | 30006.0 | 100% |
| Example 2-5 | FM-2 | 30004.0 | 30003.6 | 100% |
| Example 3-5 | FM-3 | 30012.4 | 30013.4 | 100% |
| Example 4-5 | FM-4 | 30007.3 | 30006.8 | 100% |
| Comparative Example 1-5 | Comparative FM-1 | - | - | - |
| Comparative Example 2-5 | Comparative FM-2 | - | - | - |
| Comparative Example 3-5 | Comparative FM-3 | 30003.2 | 28105.2 | 94% |
| Comparative Example 4-5 | Comparative FM-4 | 30038.4 | 30037.5 | 100% |
| Comparative Example 5-5 | Comparative FM-5 | 29983.3 | 25664.2 | 86% |
| Comparative Example 6-5 | Comparative FM-6 | 29934.6 | 28758.3 | 96% |
| Comparative Example 7-5 | Comparative FM-7 | 29955.4 | 29954.7 | 100% |
| Comparative Example 8-5 | Comparative FM-8 | 30024.2 | 30021.2 | 100% |
| Comparative Example 9-5 | Comparative FM-9 | 30004.3 | 28679.3 | 96% |
| Comparative Example 10-5 | Comparative FM-10 | 30009.3 | 30011.3 | 100% |
| Comparative Example 11-5 | Comparative FM-11 | 29844.7 | 29846.7 | 100% |

As shown in Table 9, since the polymer (A) having a structural unit shown by the general formula (1) was used in each of the inventive materials for forming a filling film for inhibiting semiconductor substrate pattern collapse (FM-1 to -4), so that high-molecular-weight compounds were successfully produced through the crosslinking reaction with the residual-solvent removal promoter (B) by heating. This consequently enabled formation of filling films excellent in solvent resistance. In contrast, in Comparative Examples 3-5, 5-5, and 6-5 using Comparative FM-3, -5, and -6 not containing the residual-solvent removal promoter (B), the production of high-molecular-weight compounds from the polymers was insufficient. Moreover, in Comparative Example 9-5 using Comparative FM-9 containing the additive (B-2) without the compound shown by the general formula (2), the solvent resistance was insufficient presumably because the crosslinking reactivity with the polymer (A) was low.

### [Planarizing Property]

The materials for forming a filling film for inhibiting semiconductor substrate pattern collapse (FM-1 to -4, Comparative FM-3 to -11) were applied to base substrates 18 (SiO₂ wafer substrates) each having a giant isolated trench pattern (FIG. 4 (W), trench width: 10 µm, trench depth: 0.10 µm), and baked at 250°C for 60 seconds. In this manner, filling films 19 were formed. Then, a step (delta in FIG. 4 (X)) between a trench portion and a non-trench portion of each filling film was observed with an atomic force microscope (AFM) NX10 manufactured by Park systems Corp. Table 10 shows the result. In this evaluation, the smaller the step, the more favorable the planarizing property. Note that, in this evaluation, a trench pattern with a depth of 0.10 µm was planarized using a material for forming a filling film for inhibiting semiconductor substrate pattern collapse such that the resulting film would normally have a thickness of approximately 0.2 µm. This is a strict evaluation condition to evaluate the planarizing property. In Comparative Examples 1-6 to 2-6, since no filling film was formed, the planarizing property was not evaluated.

**[Table 10]**

| | Composition | Planarizing property | |
|---|---|---|---|
| | | film thickness | film thickness difference |
| Example 1-6 | FM-1 | 200 nm | 40 nm |
| Example 2-6 | FM-2 | 200 nm | 50 nm |
| Example 3-6 | FM-3 | 200 nm | 35 nm |
| Example 4-6 | FM-4 | 200 nm | 30 nm |
| Comparative Example 1-6 | Comparative FM-1 | - | - |
| Comparative Example 2-6 | Comparative FM-2 | - | - |
| Comparative Example 3-6 | Comparative FM-3 | 200 nm | 60 nm |
| Comparative Example 4-6 | Comparative FM-4 | 200 nm | 60 nm |
| Comparative Example 5-6 | Comparative FM-5 | 200 nm | 50 nm |
| Comparative Example 6-6 | Comparative FM-6 | 200 nm | 80 nm |
| Comparative Example 7-6 | Comparative FM-7 | 200 nm | 75 nm |
| Comparative Example 8-6 | Comparative FM-8 | 200 nm | 45 nm |
| Comparative Example 9-6 | Comparative FM-9 | 200 nm | 60 nm |
| Comparative Example 10-6 | Comparative FM-10 | 200 nm | 35 nm |
| Comparative Example 11-6 | Comparative FM-11 | 200 nm | 70 nm |

It can be seen as shown in Table 10 that in Examples 1-6 to 4-6 using the inventive materials for forming a filling film for inhibiting semiconductor substrate pattern collapse (FM-1 to -4), the organic films had small steps between the trench and non-trench portions and were excellent in planarizing property in comparison with Comparative Examples 3-6 to 11-6 using the comparative materials for forming a filling film for inhibiting semiconductor substrate pattern collapse (FM-3 to -11). The reason that the inventive materials for forming a filling film for inhibiting semiconductor substrate pattern collapse are excellent in planarizing property is presumably because the wide molecular weight dispersity of the polymer (A) having a structural unit shown by the general formula (1) causes excellent thermal flowability during the application and during the heating. In addition, the residual-solvent removal promoter (B) having a compound shown by the general formula (2) has low molecular weight and low viscosity, presumably thereby exhibiting an effect of enhancing the flowability during the application. These can further increase the planarizing property by using Polymer (A-3) having a structural unit shown by the general formula (3) or the high-boiling-point solvent (C-2).

### [Patterning Test after Uneven-Pattern Filling, and Pattern-Collapse Inhibition Performance Test after Filling-Film Removal]

Each of the materials for forming a filling film for inhibiting semiconductor substrate pattern collapse (FM-1 to -4, Comparative FM-3 to -11) was applied onto a semiconductor substrate C and baked at 250°C for 60 seconds to form a filling film having a film thickness of 200 nm as a resist underlayer film. The film was coated with a silicon-containing resist middle layer film and baked at 200°C for 60 seconds to form an antireflective coating having a film thickness of 35 nm. The antireflective coating was coated with a monolayer resist for ArF made of a resist upper layer film material and baked at 105°C for 60 seconds to form a photoresist film (resist upper layer film) having a film thickness of 100 nm. The semiconductor substrate C had a line-and-space pattern formed thereon with an average line width of 30 nm and an average line pitch of 45 nm, but a circuit pattern formed in the resist upper layer film was transferred into a bulk portion of the semiconductor substrate C where the line-and-space pattern was not formed, so that a new pattern was formed in the bulk portion. In this way, the inventive materials for forming a filling film for inhibiting semiconductor substrate pattern collapse were evaluated in terms of: the pattern transfer as the resist underlayer films; and the pattern-collapse inhibition performance after the filling film removal.

The silicon-containing resist middle layer film was prepared from a silicon-containing resist middle layer film material obtained by: dissolving a silicon-containing polymer and an acid generator PAG1 shown below in an organic solvent containing 0.1 mass% FC-4430 (manufactured by Sumitomo 3M Ltd.) according to proportions shown in Table 11; and filtering the solution through a filter having a pore size of 0.1 µm and made of a fluorinated resin.

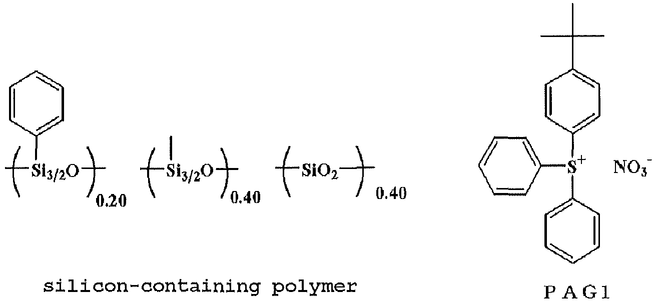

**[Table 11]**

| | Polymer | Acid generator | Organic solvent | Water |
|---|---|---|---|---|
| | (parts by mass) | (parts by mass) | (parts by mass) | (parts by mass) |
| Silicon-containing resist middle layer film material | silicon-containing polymer (100) | PAG1 (2.0) | PGEE (4000) | water (60) |

| | | | | |
|---|---|---|---|---|
| PGEE: propylene glycol ethyl ether | | | | |

The resist upper layer film material (resist film material for ArF) was prepared by: dissolving a resist polymer, an acid generator PAG2, and a quencher shown below in an organic solvent containing 0.1 mass% FC-4430 (manufactured by Sumitomo 3M Ltd.) according to proportions shown in Table 12; and filtering the solution through a filter having a pore size of 0.1 µm and made of a fluorinated resin.

**[Table 12]**

| Resist upper layer film material | Polymer (parts by mass) | Acid generator (parts by mass) | Quencher (parts by mass) | Organic solvent (parts by mass) |
|---|---|---|---|---|
| Resist film material for ArF | resist polymer (100) | PAG2 (6.0) | quencher (5.0) | PGMEA (2000) |

### Resist polymer

### molecular weight (Mw)=7,500

### dispersity (Mw/Mn)=1.9

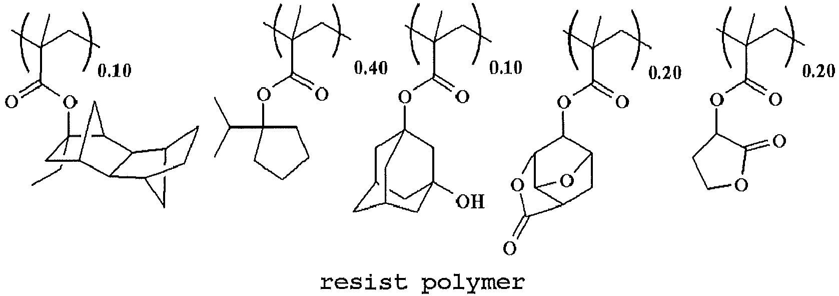

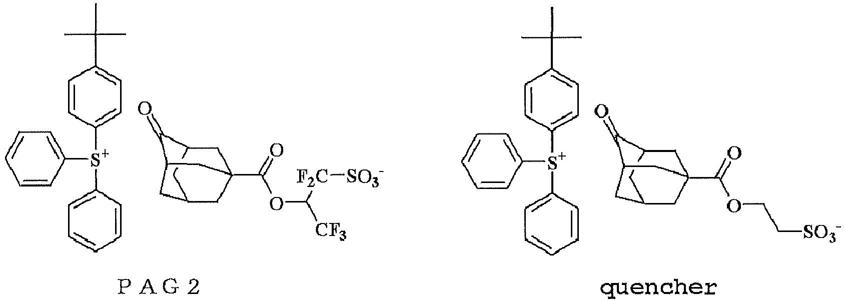

Then, the resulting substrate was exposed to light with an ArF liquid immersion exposure apparatus (manufactured by Nikon Corporation; NSR-S610C, NA: 1.30, σ: 0.98/0.65, 35° s-polarized dipole illumination, 6% halftone phase shift mask), baked (PEB) at 100°C for 60 seconds, and developed with a 2.38 mass% tetramethylammonium hydroxide (TMAH) aqueous solution for 30 seconds. Thus, a 60-nm 1:1 line-and-space pattern was obtained.

Next, while the resist pattern thus formed was used as a mask, the pattern was transferred to the silicon-containing resist middle layer film by dry etching using an etching apparatus Telius manufactured by Tokyo Electron Limited. Further, while the silicon-containing resist middle layer film having the transferred pattern was used as a mask, the pattern was transferred to the filling film by dry etching similarly. While the filling film having the transferred pattern was used as a mask, the pattern was transferred onto the semiconductor substrate C.

The etching conditions were as follows.

Conditions for transferring the pattern to the silicon-containing resist middle layer film:

| | |
|---|---|
| Chamber pressure: | 7.0 Pa |
| RF power: | 500 W |
| CF₄ gas flow rate: | 150 sccm (mL/min) |
| CHF₃ gas flow rate: | 50 sccm (mL/min) |
| Time: | 15 sec |

Conditions for transferring the pattern to the filling film:

| | |
|---|---|
| Chamber pressure: | 2.0 Pa |
| RF power: | 1,000 W |
| N₂ gas flow rate: | 80 sccm (mL/min) |
| CO gas flow rate: | 320 sccm (mL/min) |
| Time: | 50 sec |

Conditions for transferring the pattern onto the semiconductor substrate C:

| | |
|---|---|
| Chamber pressure: | 10 Pa |
| RF power: | 300 W |
| CF₄ gas flow rate: | 150 sccm (mL/min) |
| CHF₃ gas flow rate: | 30 sccm (mL/min) |
| Ar gas flow rate: | 50 sccm (mL/min) |
| Time: | 200 sec |

Conditions for removing the filling film from the semiconductor substrate C:

| | |
|---|---|
| Chamber pressure: | 2.5 Pa |
| RF power: | 1,000 W |
| N₂ gas flow rate: | 500 (mL/min) |
| H₂ gas flow rate: | 30 (mL/min) |
| Time: | 30 sec |

Next, after the filling film was removed, the semiconductor substrate C was split. The pattern cross section was observed with an electron microscope (S-4700) manufactured by Hitachi, Ltd. to evaluate: the pattern profile of Pattern-B newly formed by transferring the pattern from the resist upper layer film; and the pattern-collapse inhibition performance with respect to Pattern-A having been formed in the semiconductor substrate C. Regarding the performance of inhibiting semiconductor-substrate pattern collapse, if the proportion of lines remaining without collapsing exceeded 90%, the material was evaluated as "A" (quite favorable). If the proportion of lines remaining without collapsing was more than 70% but 90% or less, the material was evaluated as "B" (favorable). If the proportion of lines remaining without collapsing was 70% or less, the material was evaluated as "C" (poor). Table 13 shows the result.

**[Table 13]**

| | Composition | Pattern profile after etching-transferring to substrate | Pattern-collapse inhibition performance after filling film removal |
|---|---|---|---|
| | | Pattern-B | Pattern-A |
| Example 1-7 | FM-1 | vertical profile | A |
| Example 2-7 | FM-2 | vertical profile | A |
| Example 3-7 | FM-3 | vertical profile | A |
| Example 4-7 | FM-4 | vertical profile | A |
| Comparative Example 1-7 | Comparative FM-1 | - | - |
| Comparative Example 2-7 | Comparative FM-2 | - | - |
| Comparative Example 3-7 | Comparative FM-3 | pattern collapsed | C |
| Comparative Example 4-7 | Comparative FM-4 | pattern collapsed | C |
| Comparative Example 5-7 | Comparative FM-5 | pattern collapsed | C |
| Comparative Example 6-7 | Comparative FM-6 | pattern collapsed | C |
| Comparative Example 7-7 | Comparative FM-7 | pattern collapsed | C |
| Comparative Example 8-7 | Comparative FM-8 | pattern collapsed | C |
| Comparative Example 9-7 | Comparative FM-9 | pattern collapsed | C |
| Comparative Example 10-7 | Comparative FM-10 | pattern peeled | C |
| Comparative Example 11-7 | Comparative FM-11 | pattern twisted | C |

Since the inventive materials for forming a filling film for inhibiting semiconductor substrate pattern collapse (FM-1 to -4) were not only excellent in solvent resistance but also excellent in filling property and planarizing property, the resist upper layer pattern was favorably transferred to the bulk portion of the final semiconductor substrate C. The new pattern (Pattern-B) was successfully formed, which was different from the pattern (Pattern-A) originally formed in the semiconductor substrate C.

In contrast, the pattern collapses of Pattern-B were observed due to degradation of film thickness uniformity and planarizing property in: Comparative Examples 3-7 and 5-7 using Comparative FM-3 and -5 not containing the residual-solvent removal promoter (B); Comparative Example 8-7 using Comparative FM-8 to which the residual-solvent removal promoter (B) was excessively added; and Comparative Example 9-7 using Comparative FM-9 containing the additive (B-2) without containing the compound shown by the general formula (2) as the residual-solvent removal promoter (B).

Meanwhile, in Comparative Example 4-7 using Comparative FM-4 containing an acid generator, the planarizing property was significantly impaired due to the curved substrate pattern by heating, and considerable pattern collapse was observed. Moreover, in Comparative Examples 6-7 and 7-7 using Comparative FM-6 and -7 containing Polymer (A-5) with narrow molecular weight dispersity (Mw/Mn) of the polymer and poor flowability, the filling films did not fill the pattern bottom portions completely, so that the planarizing property was significantly degraded, and pattern collapse presumably occurred. In Comparative Example 10-7 using Comparative FM-10 containing Polymer (A-3), partial peeling and disappearance of the pattern were observed. This is presumably due to the high hydrophobicity of the polymer and low adhesiveness between the filling film and the semiconductor substrate pattern. Further, in Comparative Example 11-1 using Polymer (A-6) not containing the structural unit shown by the general formula (1), pattern twisting was observed. This is presumably due to lowered crosslinking density. Regarding the pattern-collapse inhibition performance with respect to Pattern-A after the filling film removal, the results were the same as those of the Examples 1-3 to 4-3 and Comparative Examples 1-3 to 11-3.

From the above, the inventive materials for forming a filling film for inhibiting semiconductor substrate pattern collapse have favorable film formability and film thickness uniformity, and are excellent in filling property for high-aspect-ratio patterns. Thus, the inventive materials are quite useful for washing fine semiconductor substrate patterns and useful as filling films for inhibiting pattern collapse in a drying step. It has also been revealed that the inventive treatment method using such materials enables treatment resulting in quite small metal impurity amount on the semiconductor substrate surface after the filling-film removal. Furthermore, since the filling films are also excellent in solvent resistance and planarizing property, the filling films are useful as resist underlayer films in multilayer resist processes, and capable of precisely forming new fine patterns on pattern-formed semiconductor substrates with high aspect ratio.

It should be noted that the present invention is not limited to the above-described embodiments. The embodiments are just examples, and any embodiments that substantially have the same feature and demonstrate the same functions and effects as those in the technical concept disclosed in claims of the present invention are included in the technical scope of the present invention. The scope of the present invention is defined by the appended claims.

## Claims

1. A material for forming a filling film for inhibiting semiconductor substrate (1,4) pattern collapse, the material comprising:
(A) a polymer having a structural unit shown by the following general formula (1);
(B) a residual-solvent removal promoter containing a compound shown by the following general formula (2); and
(C) an organic solvent,
wherein a ratio Mw/Mn of a weight-average molecular weight Mw and a number-average molecular weight Mn of the polymer (A) in terms of polystyrene by a gel permeation chromatography method is 2.50≤Mw/Mn≤9.00,
the residual-solvent removal promoter (B) is contained in an amount of 0.1 to 40 parts by mass based on 100 parts by mass of the polymer (A), and
the material for forming a filling film for inhibiting semiconductor substrate pattern collapse comprises no acid generator, 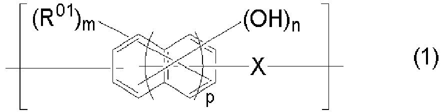 wherein R⁰¹ represents a saturated or unsaturated monovalent organic group having 1 to 30 carbon atoms; X represents a divalent organic group having 1 to 30 carbon atoms; "m" represents an integer of 0 to 5, "n" represents an integer of 1 to 6, and m+n is an integer of 1 or more and 6 or less; and "p" represents 0 or 1, 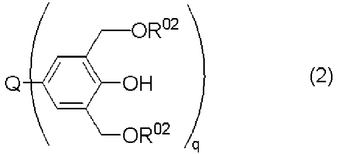 wherein Q represents a single bond, or a hydrocarbon group with a valency of "q" having 1 to 20 carbon atoms; R⁰² represents a hydrogen atom or a methyl group; and "q" represents an integer of 1 to 5.

2. The material for forming a filling film for inhibiting semiconductor substrate pattern collapse according to claim 1, wherein
the polymer (A) has a structural unit shown by the following general formula (3) in addition to the structural unit of the general formula (1), 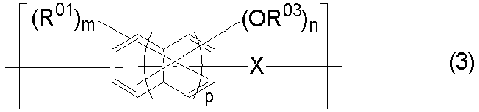 wherein R⁰³ represents a saturated or unsaturated monovalent organic group having 1 to 30 carbon atoms; "m" represents an integer of 0 to 5, "n" represents an integer of 1 to 6, and m+n is an integer of 1 or more and 6 or less; "p" represents 0 or 1; and R⁰¹ and X are as defined above.

3. The material for forming a filling film for inhibiting semiconductor substrate pattern collapse according to claim 2, wherein R⁰³ in the general formula (3) represents an alkyl group having 1 to 30 carbon atoms, or any of structures shown in the following general formula (4), 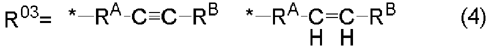 wherein * represents an attachment point to an oxygen atom, R^{A} represents a divalent organic group having 1 to 10 carbon atoms optionally having a substituent, and R^{B} represents a hydrogen atom or a monovalent organic group having 1 to 10 carbon atoms optionally having a substituent.

4. The material for forming a filling film for inhibiting semiconductor substrate pattern collapse according to claim 2 or 3, wherein the structural unit of the general formula (3) is contained in an amount satisfying relations of a+b=100 and b≤90, where "a" represents a proportion of the general formula (1), and "b" represents a proportion of the general formula (3).

5. The material for forming a filling film for inhibiting semiconductor substrate pattern collapse according to any one of claims 1 to 4, wherein the organic solvent (C) comprises a high-boiling-point solvent.

6. The material for forming a filling film for inhibiting semiconductor substrate pattern collapse according to claim 5, wherein the high-boiling-point solvent comprises one or more organic solvents each having a boiling point of 180°C or higher.

7. The material for forming a filling film for inhibiting semiconductor substrate pattern collapse according to any one of claims 1 to 6, further comprising (D) a surfactant.

8. The material for forming a filling film for inhibiting semiconductor substrate pattern collapse according to any one of claims 1 to 7, wherein a metal impurity amount in the material for forming a filling film for inhibiting semiconductor substrate pattern collapse is 3 ppb or less by mass.

9. The material for forming a filling film for inhibiting semiconductor substrate pattern collapse according to claim 8, wherein the metal is selected from Na, Mg, K, Ca, Mn, Fe, Ni, Cu and Ti.

10. A method for treating a semiconductor substrate (1,4), comprising steps of:
forming a filling film by using the material for forming a filling film for inhibiting semiconductor substrate pattern collapse according to any one of claims 1 to 9 to fill a semiconductor substrate having an uneven pattern formed on a surface thereof, the substrate having an aspect ratio of 5 or more; and
removing the filling film; or
a method for treating a semiconductor substrate having an uneven pattern formed on a surface thereof to dry the semiconductor substrate, the method comprising steps of:
(1) washing the pattern-formed semiconductor substrate with a washing liquid (2), or washing the pattern-formed semiconductor substrate with a washing liquid and then replacing the washing liquid with a rinsing liquid;
(2) filling the pattern with a filling film (5) in place of the washing liquid or rinsing liquid by using the material for forming a filling film for inhibiting semiconductor substrate pattern collapse according to any one of claims 1 to 9;
(3) curing the filling film by heating at a temperature of 100°C or higher and 600°C or lower for 10 to 600 seconds; and
(4) removing the cured filling film from the semiconductor substrate by dry etching.

11. The method for treating a semiconductor substrate having a first uneven pattern formed on a surface thereof to dry the semiconductor substrate according to claim 10, wherein the method is further to form a second uneven pattern different from the first uneven pattern in the semiconductor substrate, the method comprising after step (3) and before step (4) the further steps of:
(3a) forming a silicon-containing resist middle layer film (6) on the cured filling film by using a silicon-containing resist middle layer film material;
(3b) forming a resist upper layer film (7) on the silicon-containing resist middle layer film by using a photoresist composition;
(3c) forming a circuit pattern (7a) in the resist upper layer film;
(3d) transferring the pattern to the silicon-containing resist middle layer film by etching while using the circuit pattern-formed resist upper layer film as a mask;
(3e) transferring the pattern to the cured filling film by etching while using the pattern-transferred silicon-containing resist middle layer film as a mask;
(3f) forming the second uneven pattern different from the first uneven pattern in the semiconductor substrate having the first uneven pattern formed on the surface by etching while using the pattern-transferred cured filling film as a mask.

12. The method for treating a semiconductor substrate according to claim 10 or 11, wherein after the cured filling film is removed from the semiconductor substrate, metal impurity amount on the surface of the semiconductor substrate is 2.0×10E⁺¹⁰ atoms/cm² or less.

13. The method for treating a semiconductor substrate according to any one of claims 10 to 12, wherein the washing liquid or rinsing liquid is a liquid containing any one or more of water, a water-soluble alcohol, and a fluorine compound.

## Patentansprüche

1. Material zur Bildung eines Füllfilms zum Verhindern des Kollabierens von Halbleitersubstratmustern (1,4), wobei das Material umfasst:
(A) ein Polymer mit einer Struktureinheit, die durch die folgende allgemeine Formel (1) dargestellt ist;
(B) einen Restlösungsmittelentfernungsförderer, der eine Verbindung enthält, die durch die folgende allgemeine Formel (2) dargestellt ist; und
(C) ein organisches Lösungsmittel,
wobei das Verhältnis Mw/Mn des gewichtsmittleren Molekulargewichts Mw und des zahlenmittleren Molekulargewichts Mn des Polymers (A), ermittelt durch Gelpermeationschromatographie in Bezug auf Polystyrol, 2,50≤Mw/Mn≤9,00 beträgt,
der Lösungsmittelrestentfernungsförderer (B) in einer Menge von 0,1 bis 40 Massenteilen, bezogen auf 100 Massenteile des Polymers (A), enthalten ist und
das Material zum Bilden eines Füllfilms zum Verhindern des Kollabierens des Halbleitersubstratmusters keinen Säurebildner umfasst, 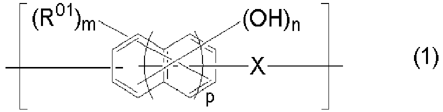 wobei R⁰¹ eine gesättigte oder ungesättigte monovalente organische Gruppe mit 1 bis 30 Kohlenstoffatomen darstellt; X eine divalente organische Gruppe mit 1 bis 30 Kohlenstoffatomen darstellt; "m" eine ganze Zahl von 0 bis 5 darstellt, "n" eine ganze Zahl von 1 bis 6 darstellt und m+n eine ganze Zahl von 1 oder mehr und 6 oder weniger ist; und "p" 0 oder 1 darstellt, 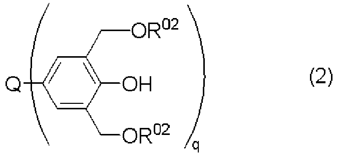 wobei Q eine Einfachbindung oder eine Kohlenwasserstoffgruppe mit einer Valenz von "q" mit 1 bis 20 Kohlenstoffatomen darstellt; R⁰² ein Wasserstoffatom oder eine Methylgruppe darstellt; und "q" eine ganze Zahl von 1 bis 5 darstellt.

2. Das Material zur Bildung eines Füllfilms zum Verhindern eines Kollabierens von Halbleitersubstratmustern nach Anspruch 1, wobei
das Polymer (A) zusätzlich zu der Struktureinheit der allgemeinen Formel (1) eine Struktureinheit der folgenden allgemeinen Formel (3) aufweist, 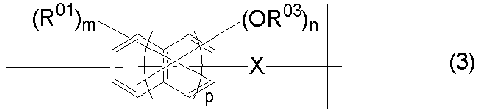
wobei R⁰³ eine gesättigte oder ungesättigte monovalente organische Gruppe mit 1 bis 30 Kohlenstoffatomen darstellt; "m" eine ganze Zahl von 0 bis 5 darstellt, "n" eine ganze Zahl von 1 bis 6 darstellt und m+n eine ganze Zahl von 1 oder mehr und 6 oder weniger ist; "p" 0 oder 1 darstellt; und R⁰¹ und X wie oben definiert sind.

3. Das Material zur Bildung eines Füllfilms zum Verhindern eines Kollabierens von Halbleitersubstratmustern nach Anspruch 2, wobei R⁰³ in der allgemeinen Formel (3) eine Alkylgruppe mit 1 bis 30 Kohlenstoffatomen oder eine der in der folgenden allgemeinen Formel (4) gezeigten Strukturen darstellt, 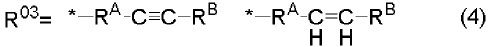 wobei * einen Bindungspunkt an ein Sauerstoffatom darstellt, R^{A} eine divalente organische Gruppe mit 1 bis 10 Kohlenstoffatomen, optional mit einem Substituenten, darstellt und R^{B} ein Wasserstoffatom oder eine monovalente organische Gruppe mit 1 bis 10 Kohlenstoffatomen, optional mit einem Substituenten, darstellt.

4. Das Material zur Bildung eines Füllfilms zum Verhindern eines Kollabierens von Halbleitersubstratmustern nach Anspruch 2 oder 3, wobei die Struktureinheit der allgemeinen Formel (3) in einer Menge enthalten ist, die die Beziehungen a+b=100 und b≤90 erfüllt, wobei "a" einen Anteil der allgemeinen Formel (1) und "b" einen Anteil der allgemeinen Formel (3) darstellt.

5. Das Material zur Bildung eines Füllfilms zum Verhindern eines Kollabierens von Halbleitersubstratmustern nach einem der Ansprüche 1 bis 4, wobei das organische Lösungsmittel (C) ein Lösungsmittel mit hohem Siedepunkt umfasst.

6. Das Material zur Bildung eines Füllfilms zum Verhindern eines Kollabierens von Halbleitersubstratmustern nach Anspruch 5, wobei das Lösungsmittel mit hohem Siedepunkt ein oder mehrere organische Lösungsmittel umfasst, die jeweils einen Siedepunkt von 180 °C oder höher aufweisen.

7. Das Material zur Bildung eines Füllfilms zum Verhindern eines Kollabierens von Halbleitersubstratmustern nach einem der Ansprüche 1 bis 6, ferner umfassend (D) ein Tensid.

8. Das Material zur Bildung eines Füllfilms zum Verhindern eines Kollabierens von Halbleitersubstratmustern nach einem der Ansprüche 1 bis 7, wobei die Menge an Metallverunreinigungen in dem Material zur Bildung eines Füllfilms zum Verhindern eines Kollabierens von Halbleitersubstratmustern 3 ppb oder weniger, bezogen auf die Masse, beträgt.

9. Das Material zur Bildung eines Füllfilms zum Verhindern eines Kollabierens von Halbleitersubstratmustern nach Anspruch 8, wobei das Metall ausgewählt ist aus Na, Mg, K, Ca, Mn, Fe, Ni, Cu und Ti.

10. Verfahren zur Behandlung eines Halbleitersubstrats (1, 4), das die folgenden Schritte umfasst:
Bilden eines Füllfilms unter Verwendung des Materials zur Bildung eines Füllfilms zum Verhindern eines Kollabierens von Halbleitersubstratmustern nach einem der Ansprüche 1 bis 9, um ein Halbleitersubstrat mit einem auf einer Oberfläche davon gebildeten ungleichmäßigen Muster zu füllen, wobei das Substrat ein Aspektverhältnis von 5 oder mehr aufweist; und
Entfernen des Füllfilms; oder Verfahren zur Behandlung eines Halbleitersubstrats mit einem auf einer Oberfläche davon ausgebildeten unebenen Muster, um das Halbleitersubstrat zu trocknen, wobei das Verfahren die folgenden Schritte umfasst:
(1) Waschen des mit einem Muster versehenen Halbleitersubstrats mit einer Waschflüssigkeit (2) oder Waschen des mit einem Muster versehenen Halbleitersubstrats mit einer Waschflüssigkeit und anschließendes Ersetzen der Waschflüssigkeit durch eine Spülflüssigkeit;
(2) Füllen des Musters mit einem Füllfilm (5) anstelle der Waschflüssigkeit oder Spülflüssigkeit unter Verwendung des Materials zur Bildung eines Füllfilms zum Verhindern eines Kollabierens des Halbleitersubstratmusters nach einem der Ansprüche 1 bis 9;
(3) Härten des Füllfilms durch Erhitzen bei einer Temperatur von 100 °C oder höher und 600 °C oder niedriger für 10 bis 600 Sekunden; und
(4) Entfernen des gehärteten Füllfilms vom Halbleitersubstrat durch Trockenätzen.

11. Das Verfahren zur Behandlung eines Halbleitersubstrats mit einem auf einer Oberfläche davon ausgebildeten unebenen Muster, um das Halbleitersubstrat zu trocknen nach Anspruch 10, wobei das Verfahren ferner darin besteht, ein zweites unebenes Muster, das sich von dem ersten unebenen Muster unterscheidet, in dem Halbleitersubstrat auszubilden, wobei das Verfahren nach Schritt (3) und vor Schritt (4) die weiteren Schritte umfasst:
(3a) Ausbilden eines siliziumhaltigen Resist-Mittelschichtfilms (6) auf dem gehärteten Füllfilm unter Verwendung eines siliziumhaltigen Resist-Mittelschichtfilmmaterials;
(3b) Ausbilden eines Resist-Oberschichtfilms (7) auf dem siliziumhaltigen Resist-Mittelschichtfilm unter Verwendung einer Photoresist-Zusammensetzung;
(3c) Ausbilden eines Schaltungsmusters (7a) im Resist-Oberschichtfilm;
(3d) Übertragen des Musters auf den siliziumhaltigen Resist-Mittelschichtfilm durch Ätzen, wobei der Resist-Oberschichtfilm mit dem ausgebildeten Schaltungsmuster als Maske verwendet wird;
(3e) Übertragen des Musters auf den gehärteten Füllfilm durch Ätzen, wobei die siliziumhaltige Resist-Mittelschicht mit dem übertragenen Muster als Maske verwendet wird;
(3f) Ausbilden des zweiten unebenen Musters, das sich von dem ersten unebenen Muster unterscheidet, in dem Halbleitersubstrat, wobei das erste unebene Muster auf der Oberfläche durch Ätzen unter Verwendung des gehärteten Füllfilms mit dem übertragenen Muster als Maske ausgebildet wird.

12. Das Verfahren zur Behandlung eines Halbleitersubstrats nach Anspruch 10 oder 11, wobei, nachdem der gehärtete Füllfilm vom Halbleitersubstrat entfernt ist, die Menge an Metallverunreinigungen auf der Oberfläche des Halbleitersubstrats 2,0×10E⁺¹⁰ Atome/cm² oder weniger beträgt.

13. Das Verfahren zur Behandlung eines Halbleitersubstrats nach einem der Ansprüche 10 bis 12, wobei die Waschflüssigkeit oder Spülflüssigkeit eine Flüssigkeit ist, die eines oder mehrere von Wasser, einem wasserlöslichen Alkohol und einer Fluorverbindung enthält.

## Revendications

1. Matériau pour former un film de remplissage destiné à inhiber l'affaissement du motif de substrat semi-conducteur (1, 4), le matériau comprenant :
(A) un polymère ayant un motif structural représenté par la formule générale (1) suivante ;
(B) un promoteur d'élimination de solvant résiduel contenant un composé représenté par la formule générale (2) suivante ; et
(C) un solvant organique,
dans lequel un rapport Mw/Mn d'une masse moléculaire moyenne en poids Mw et d'une masse moléculaire moyenne en nombre Mn du polymère (A) en termes de polystyrène par une méthode de chromatographie par perméation de gel est de 2,50 ≤ Mw/Mn ≤ 9,00,
le promoteur d'élimination de solvant résiduel (B) est contenu en une quantité de 0,1 à 40 parties en masse par rapport à 100 parties en masse du polymère (A), et
le matériau pour former un film de remplissage destiné à inhiber l'affaissement du motif de substrat semi-conducteur ne comprend pas de générateur d'acide, 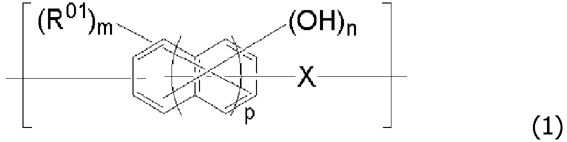
dans laquelle R⁰¹ représente un groupe organique monovalent saturé ou insaturé ayant de 1 à 30 atomes de carbone ; X représente un groupe organique divalent ayant de 1 à 30 atomes de carbone ; « m » représente un nombre entier de 0 à 5, « n » représente un nombre entier de 1 à 6, et m + n est un nombre entier de 1 ou plus et de 6 ou moins ; et « p » représente 0 ou 1, 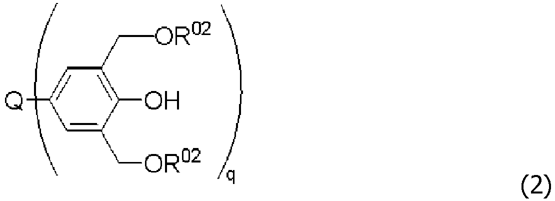
dans laquelle Q représente une liaison simple, ou un groupe hydrocarboné avec une valence de « q » ayant de 1 à 20 atomes de carbone ; R⁰² représente un atome d'hydrogène ou un groupe méthyle ; et « q » représente un nombre entier de 1 à 5.

2. Matériau pour former un film de remplissage destiné à inhiber l'affaissement du motif de substrat semi-conducteur selon la revendication 1, dans lequel
le polymère (A) a un motif structural représenté par la formule générale (3) suivante en plus du motif structural de formule générale (1), 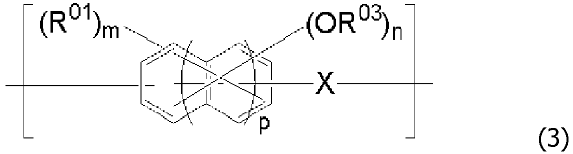
dans laquelle R⁰³ représente un groupe organique monovalent saturé ou insaturé ayant de 1 à 30 atomes de carbone ; « m » représente un nombre entier de 0 à 5, « n » représente un nombre entier de 1 à 6, et m + n est un nombre entier de 1 ou plus et de 6 ou moins ; « p » représente 0 ou 1 ; et R⁰¹ et X sont tels que définis ci-dessus.

3. Matériau pour former un film de remplissage destiné à inhiber l'affaissement du motif de substrat semi-conducteur selon la revendication 2, dans lequel R⁰³ dans la formule générale (3) représente un groupe alkyle ayant de 1 à 30 atomes de carbone, ou l'une quelconque des structures représentées dans la formule générale (4) suivante, 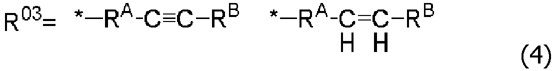 **dans laquelle** * représente un point de fixation à un atome d'oxygène, R^{A} représente un groupe organique divalent ayant de 1 à 10 atomes de carbone ayant éventuellement un substituant, et R^{B} représente un atome d'hydrogène ou un groupe organique monovalent ayant de 1 à 10 atomes de carbone ayant éventuellement un substituant.

4. Matériau pour former un film de remplissage destiné à inhiber l'affaissement du motif de substrat semi-conducteur selon la revendication 2 ou 3, dans lequel le motif structural de formule générale (3) est contenu en une quantité satisfaisant les relations de a + b = 100 et b ≤ 90, où « a » représente une proportion de la formule générale (1), et « b » représente une proportion de la formule générale (3).

5. Matériau pour former un film de remplissage destiné à inhiber l'affaissement du motif de substrat semi-conducteur selon l'une quelconque des revendications 1 à 4, dans lequel le solvant organique (C) comprend un solvant à point d'ébullition élevé.

6. Matériau pour former un film de remplissage destiné à inhiber l'affaissement du motif de substrat semi-conducteur selon la revendication 5, dans lequel le solvant à point d'ébullition élevé comprend un ou plusieurs solvants organiques ayant chacun un point d'ébullition de 180 °C ou plus.

7. Matériau pour former un film de remplissage destiné à inhiber l'affaissement du motif de substrat semi-conducteur selon l'une quelconque des revendications 1 à 6, comprenant en outre (D) un tensioactif.

8. Matériau pour former un film de remplissage destiné à inhiber l'affaissement du motif de substrat semi-conducteur selon l'une quelconque des revendications 1 à 7, dans lequel une quantité d'impureté métallique dans le matériau pour former un film de remplissage destiné à inhiber l'affaissement du motif de substrat semi-conducteur est de 3 parties par milliard ou moins en masse.

9. Matériau pour former un film de remplissage destiné à inhiber l'affaissement du motif de substrat semi-conducteur selon la revendication 8, dans lequel le métal est choisi parmi le Na, le Mg, le K, le Ca, le Mn, le Fe, le Ni, le Cu et le Ti.

10. Procédé de traitement d'un substrat semi-conducteur (1, 4), comprenant les étapes de :
formation d'un film de remplissage au moyen du matériau pour former un film de remplissage destiné à inhiber l'affaissement du motif de substrat semi-conducteur selon l'une quelconque des revendications 1 à 9 pour remplir un substrat semi-conducteur ayant un motif irrégulier formé sur une surface de celui-ci, le substrat ayant un rapport de forme de 5 ou plus ; et
retrait du film de remplissage ; ou
procédé de traitement d'un substrat semi-conducteur présentant un motif irrégulier formé sur une surface de celui-ci pour sécher le substrat semi-conducteur, le procédé comprenant les étapes de :
(1) lavage du substrat semi-conducteur à motif formé avec un liquide de lavage (2), ou lavage du substrat semi-conducteur à motif formé avec un liquide de lavage, puis remplacement du liquide de lavage par un liquide de rinçage ;
(2) remplissage du motif avec un film de remplissage (5) à la place du liquide de lavage ou du liquide de rinçage au moyen du matériau pour former un film de remplissage destiné à inhiber l'affaissement du motif de substrat semi-conducteur selon l'une quelconque des revendications 1 à 9 ;
(3) durcissement du film de remplissage par chauffage à une température de 100 °C ou plus et de 600 °C ou moins pendant 10 à 600 secondes ; et
(4) retrait du film de remplissage durci du substrat semi-conducteur par gravure à sec.

11. Procédé de traitement d'un substrat semi-conducteur ayant un premier motif irrégulier formé sur une surface de celui-ci pour sécher le substrat semi-conducteur selon la revendication 10, dans lequel le procédé consiste en outre à former un second motif irrégulier différent du premier motif irrégulier dans le substrat semi-conducteur, le procédé comprenant après l'étape (3) et avant l'étape (4) les étapes supplémentaires de :
(3a) formation d'un film de couche intermédiaire de réserve contenant du silicium (6) sur le film de remplissage durci au moyen d'un matériau de film de couche intermédiaire de réserve contenant du silicium ;
(3b) formation d'un film de couche supérieure de réserve (7) sur le film de couche intermédiaire de réserve contenant du silicium au moyen d'une composition de résine photosensible ;
(3c) formation d'un motif de circuit (7a) dans le film de couche supérieure de réserve ;
(3d) transfert du motif sur le film de couche intermédiaire de réserve contenant du silicium par gravure tout en utilisant le film de couche supérieure de réserve à motif de circuit formé comme masque ;
(3e) transfert du motif sur le film de remplissage durci par gravure tout en utilisant le film de couche intermédiaire de réserve contenant du silicium à motif transféré comme masque ;
(3f) formation du second motif irrégulier différent du premier motif irrégulier dans le substrat semi-conducteur ayant le premier motif irrégulier formé sur la surface par gravure tout en utilisant le film de remplissage durci à motif transféré comme masque.

12. Procédé de traitement d'un substrat semi-conducteur selon la revendication 10 ou 11, dans lequel, après le retrait du film de remplissage durci du substrat semi-conducteur, la quantité d'impuretés métalliques sur la surface du substrat semi-conducteur est de 2,0 x 10E⁺¹⁰ atomes/cm² ou moins.

13. Procédé de traitement d'un substrat semi-conducteur selon l'une quelconque des revendications 10 à 12, dans lequel le liquide de lavage ou le liquide de rinçage est un liquide contenant un ou plusieurs éléments parmi l'eau, un alcool hydrosoluble et un composé de fluor.
